Europäisches Patentamt

**European Patent Office**

Office européen des brevets

(19)

(11)  **EP 1 705 799 A1**

(12)  **EUROPEAN PATENT APPLICATION**

(43) Date of publication:
**27.09.2006 Bulletin 2006/39**

(51) Int Cl.:
***H03M 13/37*** *(2006.01)*

(21) Application number: **05006313.0**

(22) Date of filing: **22.03.2005**

| | |
|---|---|
| (84) Designated Contracting States:<br>**AT BE BG CH CY CZ DE DK EE ES FI FR GB GR HU IE IS IT LI LT LU MC NL PL PT RO SE SI SK TR**<br>Designated Extension States:<br>**AL BA HR LV MK YU** | (72) Inventors:<br>• **Mondin, Marina**<br>  **10137 Torino (IT)**<br>• **Laddomada, Massimiliano**<br>  **74015 Martina Fionca (TA) (IT)**<br>• **Bajastani, Fereydoun Daneshgaran**<br>  **10137 Torino (IT)** |
| (71) Applicants:<br>• **Fondazione Torino Wireless**<br>  **10129 Torino (IT)**<br>• **EUROCONCEPTS S.z.l.**<br>  **10137 Torino (IT)** | (74) Representative: **Grünecker, Kinkeldey,**<br>  **Stockmair & Schwanhäusser**<br>  **Anwaltssozietät**<br>  **Maximilianstrasse 58**<br>  **80538 München (DE)** |

(54)  **A method and system for information processing**

(57)   A novel technique for information processing is provided, in which the decoding of channel encoded data is enhanced by using an inherent correlation of the data. It is demonstrated that the correlation is highly robust with respect to bit errors introduced by the transmission channel. Thus, the correlation represents additional information in decoding the data, thereby relaxing constraints in view of power supply and computational resources at the transmitter side and/or the transmission channel for a given desired quality of service.

Fig.1

**Description**

**FIELD OF THE PRESENT INVENTION**

The present invention generally relates to methods and systems used for generating and communicating information via a network including wired and/or wireless transmission channels.

The rapid advance in the field of micro optical, micro mechanical and micro electronic techniques brings about the potential for enhanced generation of information, for instance in the form of measurement data provided by sensor elements, and also promotes the vast and efficient distribution of information over a plurality of transmission channels, which are increasingly designed as wireless channels, thereby frequently providing enhanced connectivity along with improved user mobility. In this respect, the term "network" is often used for describing a system that allows data to be communicated between a plurality of network nodes, which are connected to a communication medium including one or more transmission channels so as to receive and/or transmit data from one or more of the communication channels. The transmission channels may represent wired and/or wireless communication lines, such as cables, optical fibers, or any other electromagnetic fields propagating in free space. Although the term "network" is sometimes used in the context of systems including a high number of network nodes, such as mobile 'phone subscribers linked to a plurality of base stations, computer devices linked to local and global networks, and the like, a network is to be understood in this application as a system comprising at least a first node and at least a second node connected via at least one transmission channel. Hereby, the first node and the second node may represent different physical entities or may represent the same physical entities at different states. For example, a hardware unit storing data on a memory unit and reading the stored data at a later time may also be considered to represent a first node, when storing the data, and may be considered a second node, when retrieving the data, while the memory unit may present the transmission channel.

Generally, in network communication it is intended to receive information provided as a stream of data bits transmitted from a first node to a second node via the communication channel with a minimal number of bit errors wherein, depending on the specific application and the transmission channel characteristics, more or less encoding and decoding efforts are necessary to maintain a certain desired degree of data integrity. A measure for quantitatively expressing the quality of the transmission channel is the bit error rate (BER) representing the probability of creating an erroneous bit during data transmission. In principle, each transmission channel is subjected to environmental influences, which may cause a disturbance of the initial signal fed into the transmission channel. Moreover, other physical phenomena such as noise, dispersion, and the like, may have a significant impact on the probability of creating a bit error after reconverting an analogue signal into its digital representation. Despite the unavoidable probability for any bit errors created during the transmission of a signal, the information may reliably be retrieved from the signal as long as the information capacity of the information source is less than the channel capacity and an appropriate method of encoding the source information is used. In this context, encoding source information so as to reduce the probability of providing erroneous information after decoding the transmitted signal at the receiver is referred to as channel encoding. That is, channel encoding adds complexity to the original information, for instance by providing a certain degree of redundancy, so as to allow at the receiver side to retrieve, at least to a certain desired degree, the original information irrespective of any bit errors that may have occurred during the transmission of the encoded information. It should be appreciated that the degree of channel encoding required for a reliable transmission of information depends on the channel characteristics and the source capacity, wherein the additional redundancy required for a perfectly reliable extraction of the originally encoded information may frequently be not acceptable for a plurality of applications. On the other hand many applications, such as storing data on a storage medium, transmitting "exe" files, and the like, require an extremely low bit error rate so as to not jeopardize the operation of the application when using stored data or running an "exe" file on a corresponding computer platform. Thus, data communication is frequently a compromise between information processing capabilities and data reliability and/or application performance. Consequently, information generation and information transmission may be described as a process in which desired information is created and is prepared for transmission in a first step that is typically referred to as source encoding. In the process of source encoding, the amount of information is reduced, for instance by removing redundancy, removing portions of information that are considered not essential for the application of interest, and the like, so as to obtain a condensed form of the initially generated information. Depending on the type of technique for compressing the information, the reduced amount of information may reflect the initial information with or without loss of data. After this source encoding, the condensed information is channel encoded, that is, additional redundancy is added to the condensed information so as to allow the correction of transmission induced bit errors or at least provide the potential to identify to a certain degree the occurrence of bit errors at the receiver side. Hereby, the efforts in channel encoding significantly determine the reliability of the data transmission for a given transmission channel and thus the feasibility or applicability in certain applications. For instance, the great advances in construction of low-cost, low-power and mass produced micro sensors and micro electro mechanical systems has ushered a new era in system design for a diverse range of applications. The advent of such devices has indeed provided one key ingredient of what may be considered as a sensory revolution. On the other hand, the ability to integrate, extract and communicate useful information from a network of distributed sensors renders the employment of distributed sensors as an attractive solution for problems involved in a plurality of applications. Consequently, research progress has been made in the past decade on addressing several issues in connection with enabling sensing nodes in a network to communicate with each other and with the outside world.

Although many of the problems encountered with distributed sensor networks are common problems also encountered in traditional fields, such as the design of microprocessors and the like, frequently more severe constraints are to be taken into consideration. That is, compared to for instance traditional data communication or terminal equipment, a significantly reduced computational power and battery power is usually available at the network nodes and thus requires a highly efficient channel encoding of data communicated over the network so as to meet the requirements with respect to computational power and battery power. Hence, it is an important aspect to design the channel encoding and the signal processing so as to reduce the transmit power for severely power limited nodes for a given fidelity criterion. For example, a network may be considered including a plurality of sensor nodes that are hierarchically arranged in a tree structure with collections of nodes at a given hierarchical level belonging to different clusters each having a cluster head. The cluster heads may be endowed with more signal processing capacity and available power in comparison to the other cluster nodes. In such an example, the cluster heads may represent aggregation nodes for data that migrates from one level of the tree hierarchy to the next. In such a configuration, the data communication from a lower rank network node to a higher rank network node or to the cluster head may suffer from reduced reliability owing to the severe constraints in transmit power and/or computational power at the network nodes of the lower rank.

In view of the situations described above, there exists a need for improved techniques for information processing so as to increase data reliability without unduly contributing to channel encoding complexity.

According to one aspect of the present invention, a method of information processing comprises: generating a first piece of information and a second piece of information in a timely-related manner and transmitting at least the first piece of information from a first source to a second source over a first transmission channel. Moreover, the method comprises decoding at least the first piece of information at the second source by using an estimated correlation of the transmitted first piece of information and the second piece of information that is available at the second source at the time of decoding at least the first piece of information.

According to this aspect of the present invention, the presence of a correlation between a first piece of information and a second piece of information, which frequently be an inherent property of the first and second pieces of information, may be exploited in decoding at least one of the pieces of information that is transmitted via the transmission channel. Hereby, the first and second pieces of information are generated in a timely-related fashion so that their time-relationship may be used in determining a specified degree of correlation at the second source. Based on the identified degree of correlation, which is highly robust with respect to error-causing mechanisms in the transmission channel, there is then in addition to the first and second pieces of information further information available for more reliably decoding at least the first piece of information at the receiver side, thereby providing the potential for relaxing the constraints with respect to channel encoding at the transmitter side or to improve the data transmission reliability for a given configuration of the first source, the second source and the transmission channel. Consequently, due to the fact that the correlation existing in the initially generated first and second pieces of information is highly robust during transmission, any sources, such as network nodes receiving the first and/or second piece of information, may more reliably communicate information while nevertheless meeting even highly severe constraints, for instance, with respect to power availability and computational resources.

In a further preferred embodiment, decoding at least the first piece of information comprises iteratively decoding the first piece of information using a soft decision algorithm. As is generally known, channel decoding on the basis of iterative decoding techniques including soft decision criteria, as is frequently used in conventional decoding schemes, may significantly be enhanced by also exploiting the inherent cross-correlation between the first and second pieces of information.

In one preferred embodiment, iteratively decoding at least the first piece of information comprises partially decoding the first piece of information in a first iteration step, estimating a first correlation value relating the partially decoded first piece of information to the second piece of information and finally using the first correlation value in decoding the first piece of information in a second iterative step.

Thus, by estimating the first correlation value on the basis of the first piece of information as decoded in the first iterative step, well-approved iterative decoding techniques may be used and may thereafter be enhanced by providing the first correlation value in a subsequent iteration step, wherein the additional information conveyed by the correlation value may allow a more reliable assessment of the correctness of the first piece of information. Since the first correlation value is provided on the basis of the preliminarily decoded first piece of information and the second piece of information, no "side information" is required so as to enhance the further decoding process, that is, neither the transmission channel nor the first source is loaded with additional information, while nevertheless providing for enhanced means in deciding whether or not a bit of the first piece of information has been correctly transmitted or not.

In a further embodiment, the first correlation value is used to readjust at least one decision criterion of the soft decision algorithm. Consequently, the first correlation value, obtained without any side information with respect to the first source or the transmission channel, may allow to readjust a decision threshold in a subsequent iterative step, thereby reducing the number of iterations required or enhance the data reliability for a given number of iteration steps.

In a further embodiment, iteratively decoding the first piece of information comprises partially decoding the first piece of information as obtained after the second iterative step, estimating a second correlation value relating the first piece of information partially decoded twice to the second piece of information, and using the second correlation value in decoding the first piece of information in a third iterative step.

According to this embodiment, a further iterative step may be performed on the basis of an updated correlation value, which is calculated on the basis of the decoded first piece of information, which is already based on a previously calculated correlation value. Consequently, by using an updated correlation value the further iteration process may even be more enhanced, since the accuracy of the updated correlation value may improve, even though the correlation between the first and second pieces of information is of high reliability in the preceding iterative steps due to the high robustness with respect to channel-induced errors.

In a further advantageous embodiment, the second piece of information is transmitted to the second source via a second transmission channel. In this arrangement, the second piece of information may be conveyed in a similar fashion as the first piece of information wherein, as explained with reference to the first piece of information, the correlation initially present for the first and second pieces of information is substantially maintained, although the second transmission channel may also be subjected to bit errors. Thus, the first and second pieces of information may be generated by correlated information sources, wherein the robust correlation between the first and second pieces of information may be used in decoding the first and second pieces of information with an enhanced degree of reliability.

In a further embodiment, the second piece of information is transmitted via the first transmission channel. In this configuration, the second piece of information may be made available at the second source by means of the first transmission channel, wherein the robustness of the correlation may assist in decoding the first and/or the second piece of information. For example, the first and second pieces of information may be generated at disjoint information sources connected to the same network node, or the first and second pieces of information may be generated by one or more applications running at a specified platform connected to a specified network node, or the first and second pieces of information may represent respective portions of information generated by a single information source.

In a further embodiment, the first piece of information is generated at the first source and the second piece of information is generated at the second source. In this configuration, the second piece of information may not necessarily be transmitted via a transmission channel but may instead be directly used without any further encoding and decoding process. For instance, the first and second sources may represent sensory network nodes connected by the first transmission channel so that the second sensory network node may receive information via the first transmission channel and may be able to decode the information with enhanced reliability due to exploiting the fact that a high degree of correlation, that is, a high degree of similarity or dissimilarity, may be present between the first and second pieces of information.

In another configuration, the first piece of information is generated at the first source and the second piece of information is generated at a third source. Thus, the first and second pieces of information may be transmitted via respective transmission channels so as to be received and decoded at the second source. As an illustrative example, the first and third sources may be considered as sensory network nodes communicating with the first source, representing a further sensory network node that may have increased computational power and supply power compared to the first and third sources, which may be operated with severe constraints regarding computational resources and supply power.

Hereby, despite the limited channel encoding and supply power capabilities of the first and third sources data may be transferred to the second source at high reliability, since transmission induced errors may efficiently be identified due to the additional information conveyed by the correlation and usable for decoding.

In a further embodiment, the first piece of information is one of a plurality of first pieces of information that are transmitted via a plurality of first transmission channels, which include the first transmission channel, to a plurality of second sources including the second source, wherein each of the plurality of first sources at least transmits at least one of the plurality of first pieces of information and wherein each of the plurality of second sources receives at least one of the plurality of first pieces of information, wherein each of the plurality of second sources has access to at least one of a plurality of second pieces of information, which include the previously mentioned second piece of information, and wherein the method further comprises decoding the plurality of first pieces of information at the plurality of second sources while using respective estimated correlations of the plurality of first pieces of information with the plurality of second pieces of information.

With this arrangement, a plurality of sources may transmit respective information to a plurality of receiving sources, wherein at the receiving side the possible correlation between one or more received messages and at least one second piece of information available at each of the receiving sources is used for an enhanced channel decoding. Consequently, the above configuration is highly advantageous in operating a network including a plurality of transmitting network nodes and having a plurality of receiving network nodes. Although not necessary for practicing the present invention, this configuration may be highly advantageous if the first sources may represent sources of reduced computational resources and/or power supply compared to the receiving second sources.

In one preferred embodiment, the method further comprises transmitting the first piece of information without data compression prior to any channel encoding of the first piece of information. This embodiment is highly advantageous in applications in which source encoding is a less attractive approach since source encoding, although used for reducing the number of bits transferred via a transmission channel, puts most of the signal processing burden at the information source, thereby requiring highly advanced computational resources and power supply. Furthermore, when the data packet size is moderately small, as is often the case in distributed sensor networks, source encoding may make no sense and may in fact cause data expansion rather than compaction.

In a further preferred embodiment, the method additionally comprises determining the estimated correlation by comparing first data bits representing the first piece of information with second data bits representing the second piece of information by a logic operation. Thus, highly efficient means for assessing the degree of correlation between the first and second pieces of information are provided, thereby also reducing the amount of computational resources at the second, that is, the receiving, source.

In a further embodiment, the method further comprises obtaining the estimated correlation by determining a comparison result on the basis of a number of agreements of the comparison and by normalizing the comparison result. Consequently, according to this embodiment the correlation may readily be determined by, for instance, counting the number of agreements or the number of disagreements between corresponding bits representing the first piece of information and the second piece of information, respectively, so that this comparison result may readily be used, when appropriately normalized, for the further process of decoding the data bits in a further iterative step.

In preferred embodiments, the first piece and the second piece are iteratively decoded, advantageously in a common sequence using the estimated correlation, obtained after a first step, in evaluating a newly-decoded version of the first and second pieces of information on the basis of the estimated correlation calculated after the previous iteration step.

In further advantageous embodiments, at least the first piece of information is channel-encoded, wherein in one embodiment the channel encoding comprises a low density parity check for the encoding of the first piece of information, while in another embodiment the channel encoding comprises a serially concatenated convolutional code.

In a further embodiment, the first and the second pieces of information are both channel-encoded by the same encoding method.

According to a further aspect of the present invention, a method of channel decoding at least first data representing a first piece of information generated by a first source and second data representing a second piece of information generated by a second source is provided, wherein the first and second data have a specified degree of correlation. The method comprises receiving the first and second data, decoding at least the first data in a first step, determining an estimate of the degree of correlation on the basis of the first data decoded in the first step and the second data and decoding at least the first data in a second step on the basis of the estimate of the degree of correlation.

As previously already pointed out, the present invention provides a novel technique for channel decoding data received via a transmission channel, wherein the decoding is performed in at least two steps while using the correlation between the first and second data so as to enhance the reliability of the decoding process. As previously discussed, in many applications requiring the data transfer via transmission channels of a network, the information received at a specified network node may include correlated portions or information received from different network nodes may bear a certain correlation, which is maintained to a high degree irrespective of any bit errors occurring during the transfer of information, as will be discussed in more detail later on. Thus, by receiving the first and second data, wherein at least the first data may be channel encoded and transmitted via a specified transmission channel, the first data may be decoded on the basis of additional information regarding the first and second data, i.e., their mutual correlation, without requiring additional resources at the transmitter side and in the transmission channel. Thus, the inventive method is highly advantageous in network applications having a hierarchical structure with severe constraints with respect to computational resources and/or power supply at the transmitting side. It should be emphasized, however, that the present invention is also applicable to any information processing of information generated by correlated disjoint sources, wherein at least a portion of the information is communicated via a transmission channel. For example, the communication of slowly changing measurement results over a noisy transmission channel may significantly be improved by exploiting the presence of correlation between two subsequent messages. Also, in other network applications the transmission of subsequent similar data or dissimilar data may provide the receiver side with additional implicit information, that is, the correlation between subsequent messages, so as to enhance the channel decoding process.

In preferred embodiments, the first data and the second data may be decoded. In this configuration, both the first data and the second data may be transmitted via one or more transmission channels, wherein the decoding process exploits the inherent correlation so as to enhance the decoding reliability for both the first and second data irrespective of the error mechanisms acting on the respective transmission channels.

According to a further aspect of the present invention, a communication network is provided. The communication network comprises a first node including a channel encoder configured to encode a first piece of information. The network further comprises a second node including a channel decoder configured to decode the channel encoded first piece of information on the basis of an estimated correlation between the first piece of information and a second piece of information that is communicated over the network and is available at the second node at the time of decoding the first piece of information. The second node further includes a correlation estimator that is configured to provide a value indicating the estimated correlation to the channel decoder. Additionally, the network comprises a communication medium providing one or more communication channels and being connected to the first and second nodes and being configured to convey at least the channel encoded first piece of information to the second node.

As previously discussed with respect to the first and second aspects of the present invention, the concept of using additional inherent information in the form of a correlation existing between a first piece of information that may be communicated via a communication channel, and a second piece of information, which is available at the time of decoding the first piece of information at the receiver side, may also advantageously be applied to a communication network so as to enhance the decoding reliability for a given configuration of the transmitter side and the communication channel, or to lessen the burden at the transmitter side and/or the communication channel for a desired degree of quality of surface.

Moreover, the communication network specified above may be provided in multiple configurations and embodiments, some of which are described with respect to the method of information processing and the method of channel decoding, wherein also a plurality of advantages are provided that also apply to the inventive communication network. In particular, the communication network allows for improved communication between nodes in a network by allowing to reduce or identify the errors caused by transmission via the communication channel. Thus, a more efficient utilization of the available band width of the communication channel is accomplished thereby, for instance, reducing the number of times a message may have to be retransmitted in order for it to be received reliably at the destination node. Hereby, the first piece and the second piece of information may be generated by disjoint sources, wherein the term "disjoint sources" may include multiple segments of the same message generated by a single source, segments of messages generated by different sources, segments of messages generated by multiple applications producing traffic at a single network node or any combination of the preceding configurations. Consequently, the inventive concept of a communication network may be applicable to a wide variety of applications. Moreover, the number of disjoint information sources that are processed by a given network node may vary and may particularly include the following combinations.

A disjoint node sends a piece of information or a message that is relayed by another node, which in turn may have access to information that is correlated to the information sent by the first node. In this scenario, the receiving node may decode the message sent by the former node while using the message available so as to generate correlation information for enhanced decoding reliability.

A plurality of nodes send correlated information, which may be processed by a node, wherein the receiving node jointly decodes the information from the plurality of transmitting nodes using the mutually existing correlation of the information sent by the plurality of nodes.

A plurality of nodes send correlated information to a plurality of receiving nodes, wherein at each of the receiving nodes the correlation is used in enhancing the decoding process.

Moreover, any combination of the above-described scenarios may be realized based on the inventive communication network discussed above.

According to a further aspect of the present invention, a channel decoder is provided. The channel decoder comprises an input section configured to receive a first signal and a second signal and to demodulate the first and second signals to produce first and second data representing a first piece of information and a second piece of information, respectively, wherein at least the first signal is a channel-encoded signal. Moreover, the channel decoder comprises a correlation estimator configured to receive the first data and the second data and to determine a correlation value defining a degree of correlation between the first and the second data. Finally, the channel decoder comprises a decoder section connected to the input section and the correlation estimator, wherein the decoder section is configured to decode at least the first data on the basis of the correlation value.

As the inventive channel decoder is based on the same principle as the previous aspects of the invention, also the same advantages may readily be achieved by the inventive channel decoder.

In a further embodiment, the decoder section comprises an iterative soft decision decoder configured to adjust at least one soft decision threshold on the basis of the correlation value. Consequently, the inventive iterative soft decision decoder imparts improved efficiency to the inventive channel decoder compared to conventional channel decoders, without requiring any modifications at the transmitter side or the transmission channel.

According to still a further aspect of the present invention, a network node unit comprises a channel decoder as specified above and a hardware unit connectable to a network and being configured to process at least the decoded first piece of information.

In one embodiment, the hardware unit is further configured to assess a validity of the decoded first piece of information and to transmit an instruction via the network in order to instruct a resending of at least the first piece of

6

information. Thus, by applying the inventive principle, that is, using an inherent correlation of pieces of information or messages in decoding at least one of the pieces of information or messages, a highly efficient network unit is provided that is especially suited for sensor applications.

Further preferred embodiments and advantages thereof are defined in the appended claims and may also become apparent when studying the following detailed description of illustrative embodiments of the present invention in combination with the attached drawing, in which:

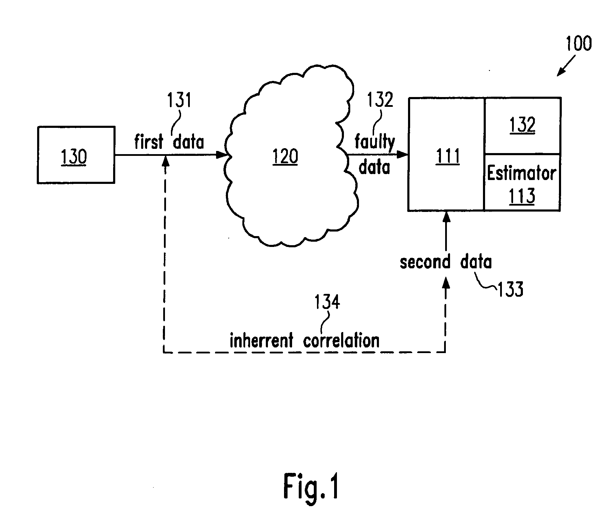

Fig. 1 schematically depicts a communication network including a channel decoder and a network node according to the present invention;

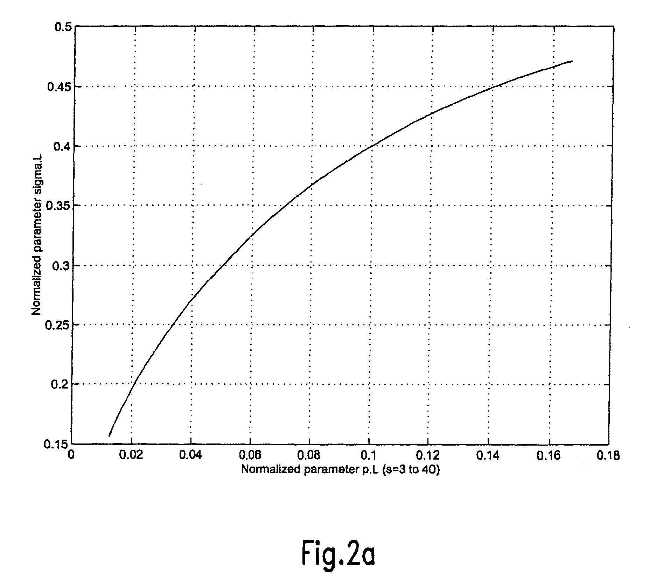

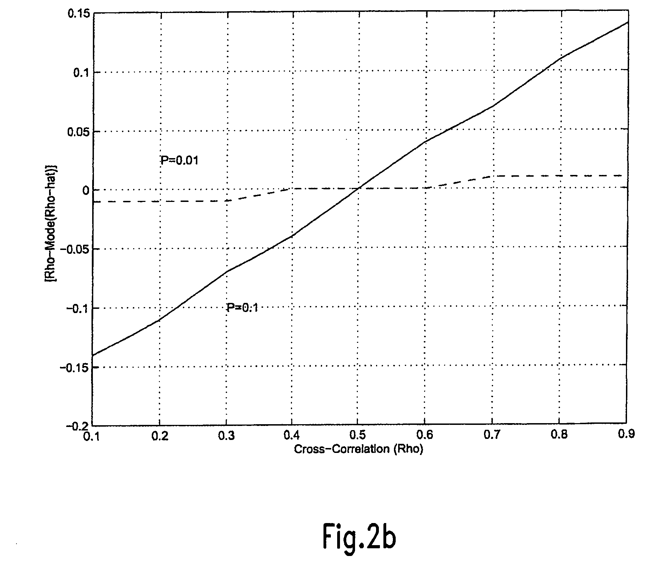

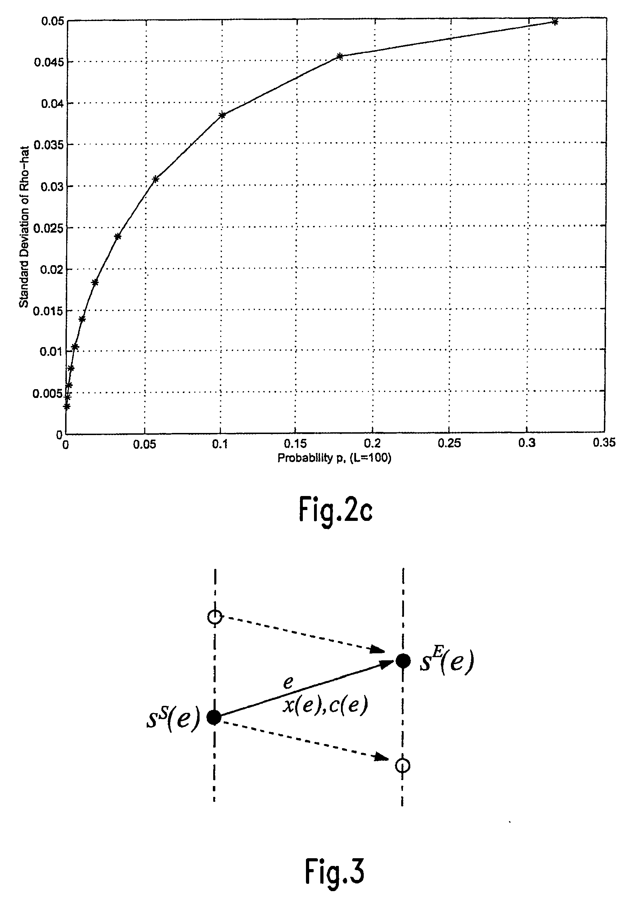

Figs. 2a - 2c show graphs of results of simulation calculations;

Fig. 3 schematically depicts a generic trellis diagram;

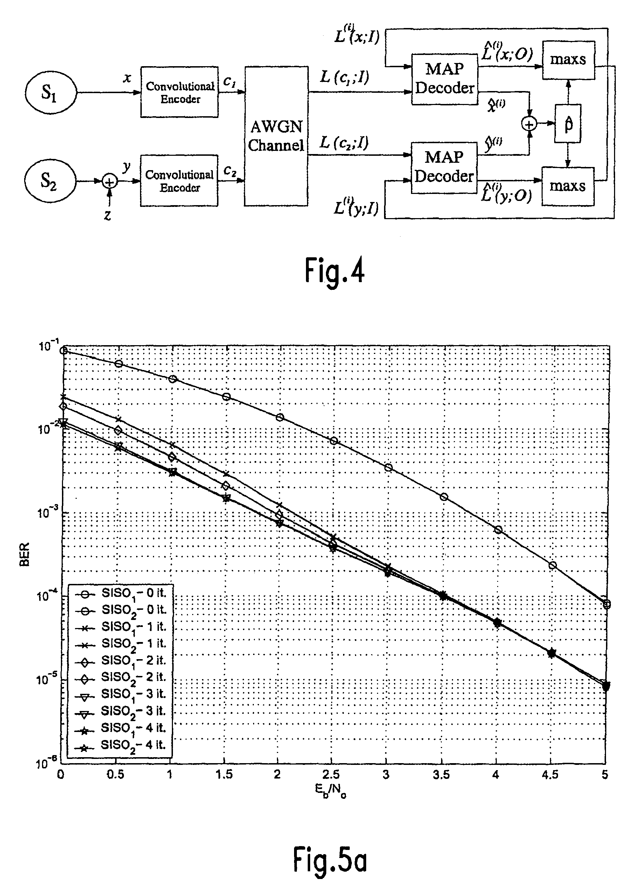

Fig. 4 schematically illustrates the architecture of a joint channel decoder according to illustrative embodiments of the present invention;

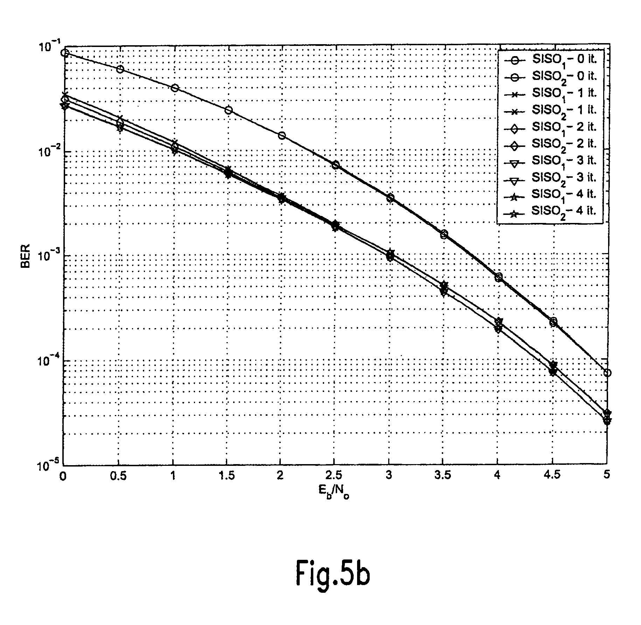

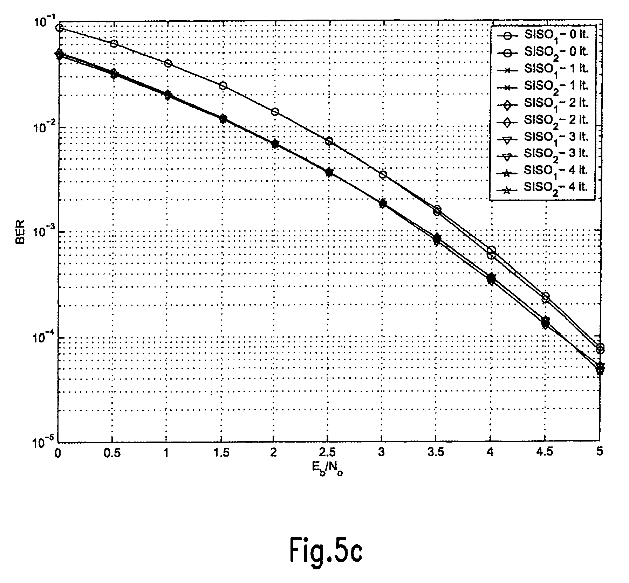

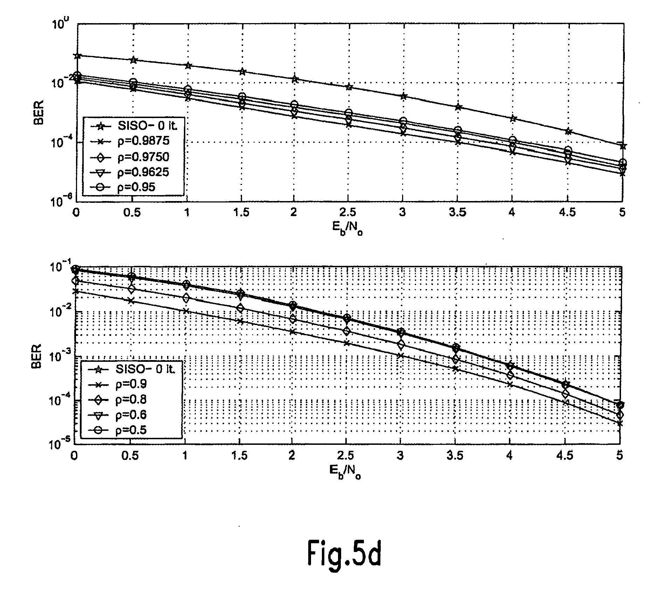

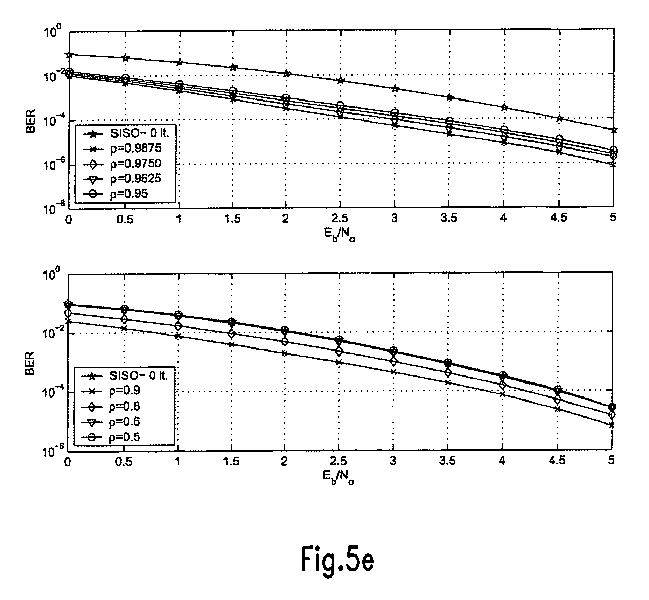

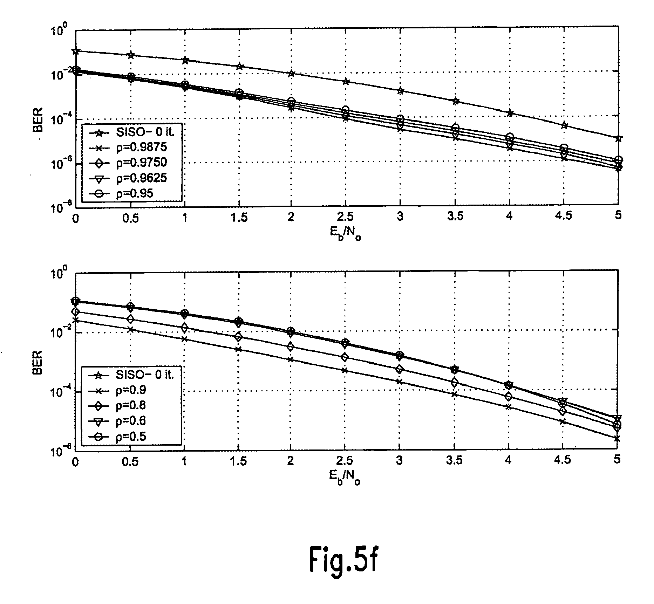

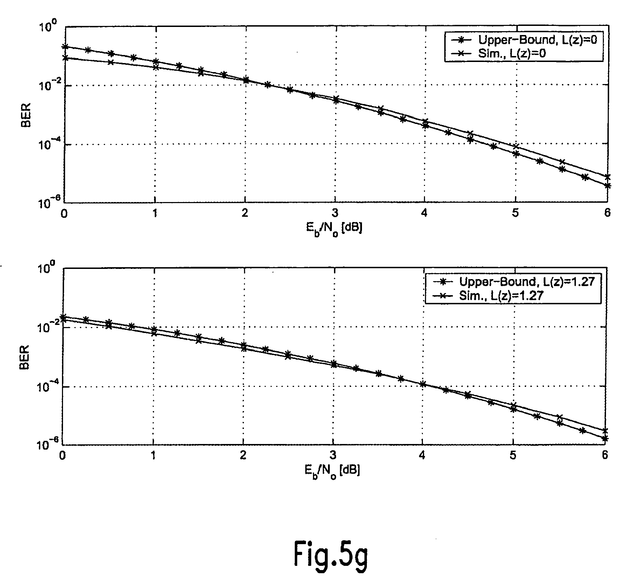

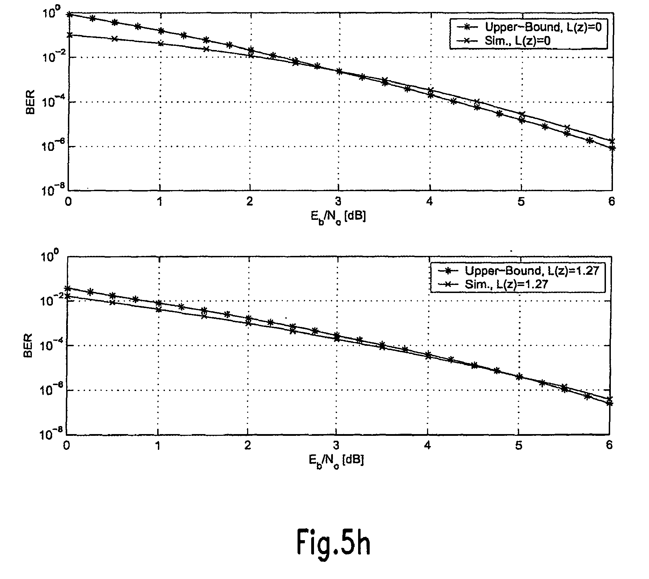

Figs. 5a - 5h depict graphs representing the results of simulations for the bit error rate with respect to the signal-to-noise ratio;

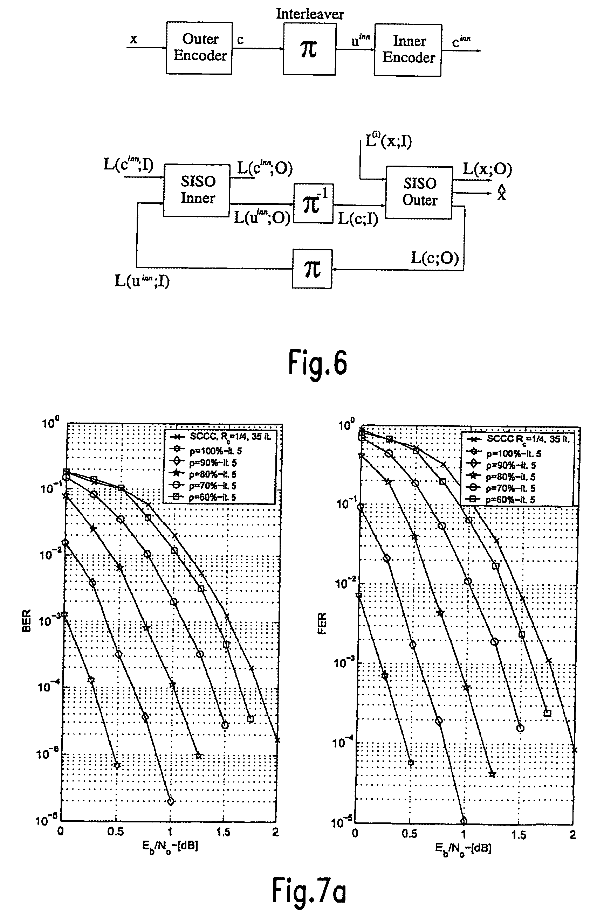

Fig. 6 schematically depicts the architecture of the encoder and iterative decoder for conventional individual serially concatenated convolutional codes (SCCC);

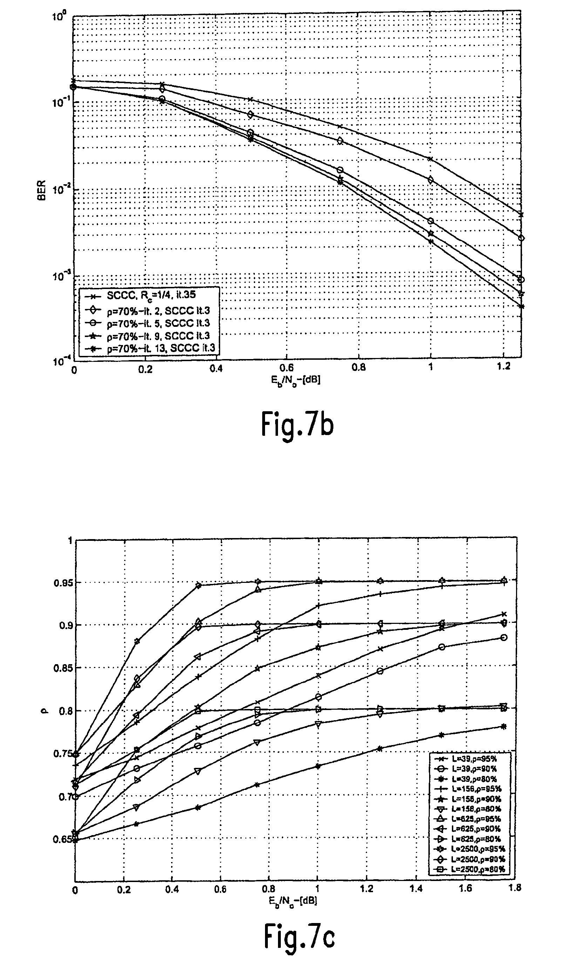

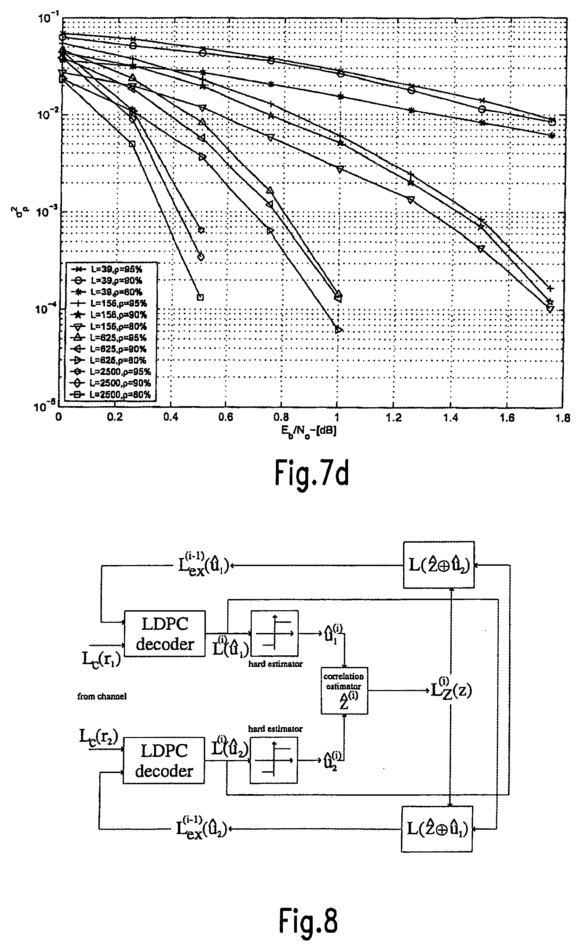

Figs. 7a - 7d represent graphs depicting the simulation results of bit error rates, frame error rates, the estimated correlation and the variance of the estimated correlation with respect to the signal-to-noise ratio for an SCCC configuration;

Fig. 8 schematically shows the architecture of a joint channel decoder of correlated sources according to the present invention, wherein channel encoding is performed according to a low density parity check (LDPC) coding method;

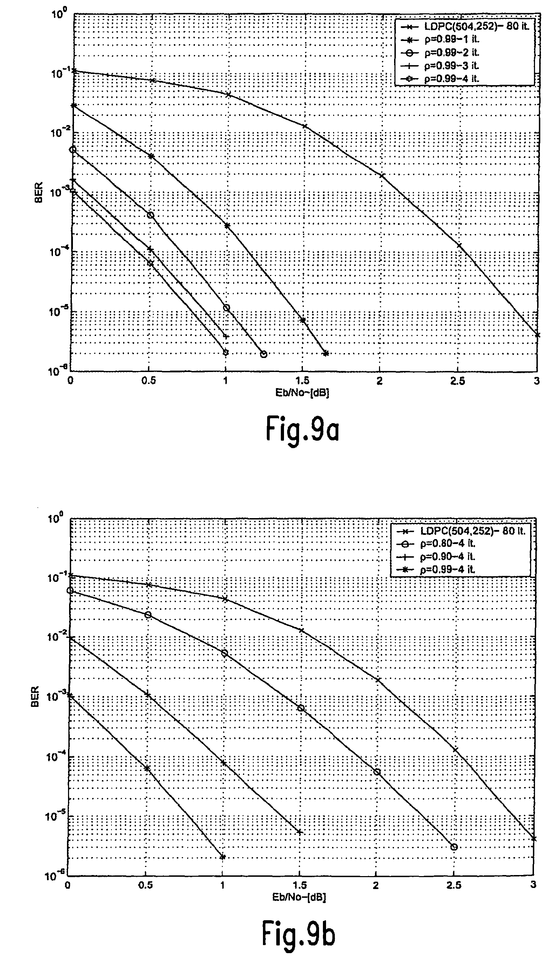

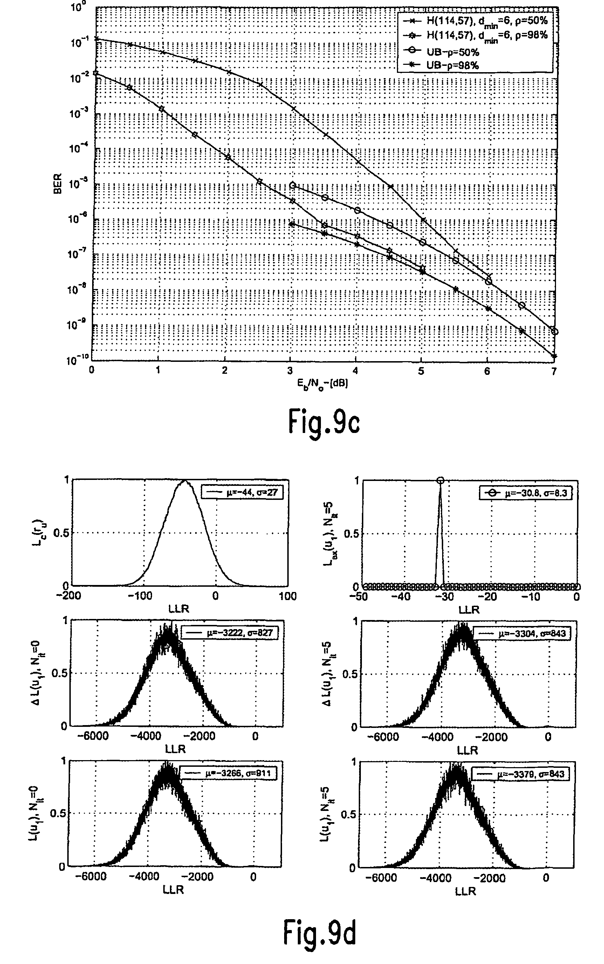

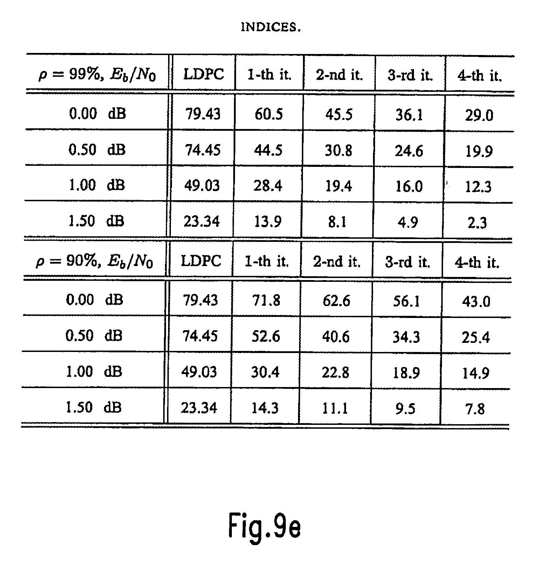

Figs. 9a - 9c represent graphs illustrating the bit error rate with respect to the signal-to-noise ratio according to simulation results; and

Fig. 9d schematically represents the empirical probability mass functions of the LLR values according to some illustrative embodiments of the present invention.

Figure (9e) shows in a table the average number of local iterations performed by the joint LDPC decoder at the end of a given global iteration, for two values of correlation between the sources.

As previously explained, the present invention exploits the potential correlation existing between multiple information sources to achieve additional coding gains from the channel codes used for data protection. Hereby, the existence of any channel side information at the receiver is neither assumed nor is it used. Rather, empirical estimates of the cross-correlation are used, in particular embodiments, in partial decoding steps in an iterative joint soft decoding paradigm.

Fig. (1) schematically shows a communication network 100, which is configured so as to use an inherent correlation between different pieces of information for channel decoding at least one of these pieces of information. The network 100 comprises a first information source 130, which may also represent a first network node including necessary hardware units and equipment so as to generate and provide a first piece of information, represented here as first data 131, to a communication medium 120, which may include one or more transmission channels. Thus, the first source 130 may represent a platform for running one or more application routines, one or more of which may produce the first data 131. The first data 131 may be provided to the communication medium 120 by any well-known means, such as cable connections and the like. For example, the first source 130 may represent a hardware unit comprising micro optical, micro mechanical and/or micro electronic components so as to generate data, channel encode the data and provide the same to the communication medium 120. In particular embodiments, the first source 130 may represent a sensor element configured to generate and provide relevant data, such as environmental data and the like. The communication medium 120 may comprise a plurality of transmission channels provided as wired and/or wireless transmission channels so that these transmission channels, depending on the specific configuration, may suffer from a certain unavoidable probability for creating channel-induced errors when conveying the first data 131 through the communication medium 120. The network 100 further comprises a second source 110, which may represent a second network node connected to the communication medium 120 so as to receive therefrom transmit data 132 that may differ from the first data 131 owing to channel-induced errors. For receiving the transmit data 132, the second source 110 may comprise an input section 111, which is further configured to receive second data 133, which may inherently be associated with the first data 131 by a specified degree of correlation 134. The inherent correlation 134 may be caused by the process of creating the first data 131 and the second data 133, for instance when the second source 110 comprises a sensor element placed in the vicinity of the first source 131 and detecting an environmental property which may not significantly differ at the locations of the first and second sources 130, 110. However, many other applications may be contemplated in which an inherent correlation between the first and second data 131, 133 may exist. For instance, both the first and second data 131, 133 may be created by the first source 130, therefore exhibiting a specified degree of similarity or dissimilarity, and may be communicated via the communication medium 120. In other embodiments, a plurality of first sources 130 may be provided, each source generating a respective set of first data 131, which may be communicated to the second source 110. Also, a plurality of second sources 110 may be provided, each of which receives first and second data having an inherent correlation that may be exploited during the decoding process for at least one of one or more sets of first data 131.

The second source or node 110 may further comprise a detection section 112 that is configured to decode the data 132 with respect to a specified channel encoding technique used in the first source 130 so as to enhance data protection during the transmission through the communication medium 120. The first source 130 further comprises a correlation estimator 113 that is connected to the input section 111 and the decoder section 112 and is configured to determine an estimation of the inherent correlation 134 and provide the estimated correlation to the decoder section 112 which, in turn, may provide an enhanced decoded version of the transmit data 132 received via the communication medium 120. As will be shown in the following, the inherent correlation 134 is quite robust with respect to any error mechanisms experienced data communicated via the communication medium 120 so that the estimated correlation provided by the estimator 113 represents a robust criterion, which may be used in more reliably decoding the faulty or error-prone transmit data 132, thereby providing the potential for reducing the effort in channel encoding the first data 131 and/or reducing the constraints with respect to bandwidth of the communication medium 120, or improving the quality of service (QoS) for a given configuration of the first source 131 and the communication medium 120. For instance, after receiving the transmit data 132 and decoding the same on the basis of the inherent correlation 134 in the second source 110, the number of instructions for resending the first data 131 due to errors in the transmit data 132 may be reduced due to the superior decoding efficiency according to the present invention.

During operation of the network 100, the first and second data 131, 133 are generated in a timely-related manner, irrespective of where the second data 133 are produced. According to the time-correlation of the first and second data 131, 133 the first and second data 131, 133 may correctly be assigned to each other and therefore appropriately processed at the second source 110. Hereby, it should be appreciated that a respective time-relationship between the first data 131 and the second data 133 may readily be established by, for instance, the sequence of receipt at the second source 110, by the time of creation of the respective data, wherein a corresponding time information may be part of the data, or any other mechanisms. Thereafter, at least the first data 131, which are to be transmitted via the communication medium 120, are channel-encoded by any appropriate encoding technique used for data protection for respective transmission channels. Later in this specification, respective configurations for convolutional coding techniques, low density parity check (LDPC) encoding techniques and serially concatenated convolutional codes (SCCC) will be described in more detail. It should be appreciated, however, that the present invention may also be used in any combination of block and convolutional coding regimes and with any form of code concatenation (serial, parallel or hybrid).

After passing through the communication medium 120, which may also represent a storage medium, as is previously explained, a certain degree of data corruption may have occurred, as is well-known for data communication over wired and wireless transmission channels, thereby creating the faulty data 132. After receiving the faulty data 132 at the first node 110 and based on the second data 133, which are available at the second source 110 at the time of decoding the faulty data 132, the decoder section 112 may provide a first estimate of a decoded version of the faulty data 132 based on conventional decoding techniques. Thereafter, the estimator 113 receiving the first estimate of the decoded data and also receiving the second data 133 may calculate an estimation of the inherent correlation 134 and may supply the estimated correlation to the decoder section 112, which in turn may determine a second estimate for the decoded faulty data 132 on the basis of the estimated correlation. For instance, the decoder section 112 may include a soft decision algorithm, in which a decision criterion may be adjusted by the estimated correlation provided by the estimator 113. Due to the additional information contained in the first data 131, 133 in the form of the inherent correlation 134, the decoding process in the second source 110 may provide a decoding result of the faulty data 132 with enhanced reliability.

In the following, the robustness of the inherent correlation 134 with respect to channel-induced error mechanisms will be explained in more detail, wherein the following assumptions are made for the sake of simplification (although our results are very general):

- the data packets to be transmitted by sources A and B, such as the first source 130, are either correlated or very different (later it will be clarified what is meant by this). The correlation may arise for instance if A and B sample an environmental parameter that does not change significantly at their locations. On the other hand, the data generated by A and B may exhibit a large difference. The key point is that the data packets generated by A and B cannot be assumed to represent for instance two sequences of independent identically distributed random variables;

- channel coding is indeed feasible and of relatively low cost. In the following the use of convolutional coding for data transmission is assumed;

- relative timing synchronicity of the nodes engaged in this communication is assumed;

- the severe power constraints at A and B preclude options such as A sending a message to B and having B relay A and B's message after some signal processing to a node C, such as the second source 110,

- the nodes engaged in communication are assumed to be stationary at least for the duration of the transmission of the packet of data.

The fundamental question addressed here is as follows; how can node C use the implicit source correlation between the encoded data packets it receives from A and B to improve the Bit Error Rate (BER) or Frame Error Rate (FER) for both data packets? If node C can achieve an improvement, then the additional coding gain obtained from the use of source correlation can be used to back-off the power at the transmit nodes A and B to conserve power for the same quality of service (i.e., a target BER or FER). It is noted that the more complex signal processing required at C to use this implicit correlation to improve performance, has a power penalty. However, it is assumed that the decrease in transmit power from A and B to C is more important and out-weighs this added signal processing cost (i.e., communication power requirements out-weigh signal processing power requirements, as is often the case).

Another scenario that could use the same process for improving performance is when node A sends a packet to node B that has a data correlated with the message sent from A. In this scenario, node B is forwarding the packet generated from node *A* in addition to sending its own packet. The potential correlation between the packet at node B and the packet sent by A can be used by the decoder at B that needs to decode A's message before forwarding it to the next node along the chain. It is noted that in a typical Distributed Sensor Networks (DSNs), 65% of the traffic at nodes is forwarded packets. Of course, the previous scenarios can be combined. The number of possibilities is large. In this example the focus shall be on the first scenario.

It is to be noted that the first scenario just described does not quite fit the conventional multiple access channel model of network information theory, whereby the data transmitted from multiple sources may interfere with each other. In particular, here we assume that sufficient statistics associated with the transmitted data from nodes A and B are both available at node C and that there is no interference between the two sources. The dual problem of Slepian-Wolf correlated source coding more closely fits the scenario just described, although here it is dealt with channel coding as opposed to source coding. Let us clarify; the result of Slepian-Wolf theorem on correlated source coding is that rates above the joint entropy are achievable even though the sources are disparate. If C can improve its BER or FER (i.e., the Quality of Service or QoS) at a fixed Signal to Noise Ratio (SNR) using the knowledge of the implicit correlation between the messages of A and B, then A and B can back-off their power levels for a fixed QoS requirement. Alternatively, A and B can utilize higher rate convolutional codes with reduced coding gains but use the same SNR level needed to achieve the required QoS if A and B's messages were independently decoded. Use of the higher rate codes at A and B means fewer channel bits transmitted to C for the same QoS, which is what the Slepian-Wolf theorem suggests is achievable. In essence, with channel coding the present invention can achieve correlated source compression without source encoding at A and B that may be too costly or infeasible.

For this scenario, the sensitivity of the cross-correlation to channel-induced errors may be estimated as follows.

In what follows, the relative robustness of the empirical cross-correlation of the received data to channel induced errors shall be demonstrated. To this end, let $\vec{X}$ and $\vec{Y}$ be two binary vectors of length L. Let us define $Z_n = X_n \oplus Y_n$ as the XOR of the n-th component of the vectors $\vec{X}$ and $\vec{Y}$. Similarly, we define $\vec{Z} = \vec{X} \oplus \vec{Y}$ whereby $\vec{Z}$ is obtained via componentwise XOR of the components of the vectors $\vec{X}$ and $\vec{Y}$.

Let the number of places in which $\vec{X}$ and $\vec{Y}$ agree be r so that the empirical cross-correlation between these two vectors is ρp = r/L. Let us suppose that what is available at the receiver are noisy versions of $\vec{X}$ and $\vec{Y}$ denoted $\hat{\vec{X}}$ and $\hat{\vec{Y}}$ respectively. For instance, $\hat{\vec{X}}$ and $\hat{\vec{Y}}$ could be erroneous versions of $\vec{X}$ and $\vec{Y}$ obtained after transmission through a noisy channel modeled as a Binary Symmetric Channel (BSC) with transition probability p. We assume that the error events inflicting the two sequences are independent identically distributed (i.i.d.). The receiver generates an empirical estimate of the cross-correlation based on the use of the sequences $\hat{\vec{X}}$ and $\hat{\vec{Y}}$ by forming the vector $\hat{\vec{Z}} = \hat{\vec{X}} \oplus \hat{\vec{Y}}$ and counting the number of places where $\hat{\vec{Z}}$ is zero. Let us denote this count as $\hat{r}$. Clearly, $\hat{r}$ is a random variable. The question is, what is the Probability Mass Function (PMF) of $\hat{r}$? Knowledge of this PMF allows us to assess the sensitivity of our estimate of the cross-correlation to errors in the original sequences.

It is relatively straightforward to find the probability that $(\hat{z}_n = z_n)$

$$\Pr(\hat{z}_n = z_n) = (1-p)^2 + p^2 \qquad (1)$$

$$\Pr(\hat{z}_n \neq z_n) = 2p(1-p), \qquad (2)$$

Consider applying a permutation to the sequences $\vec{X}$ and $\vec{Y}$ so that the permuted sequences agree in the first r locations, and disagree in the remaining (L - r) locations. The permutation is applied to simplify the explanation of how we may go about obtaining the PMF of $\hat{r}$ and by no means impacts the results. It is evident that the permuted sequence π() contains $r$ zeros in the first $r$ locations and (L - r) ones in the remaining locations. Now consider evaluation of the $\Pr(\hat{r} = r + k)$ for k = 0,1,.., (L - r). We define $\pi(\vec{Z})_r$ to represent the first r bits of $\pi(\vec{Z})$ and $\pi(\vec{Z})_{L-r}$ the remaining (L - r) bits.

Similarly we define $\pi(\hat{\vec{Z}})_r$ and $\pi(\hat{\vec{Z}})_{L-r}$. For a fixed k, the event $\{\hat{r} = r+k\}$ corresponds to the union of the events of the type: $\pi(\hat{\vec{Z}})_{L-r}$ differs from $\pi(\vec{Z})_{L-r}$ in $(k + l)$ positions for some $l \in \{0,1,.., r\}$, $\pi(\hat{\vec{Z}})_r$ differs from $\pi(\vec{Z})_r$ in $l$ positions, and the remaining bits of $\pi(\hat{\vec{Z}})$ and $\pi(\vec{Z})$ are identical. The probability of such elementary events are given by:

$$\binom{r}{l}\binom{L-r}{k+l}\left[\left[(1-p)^2 + p\right]^{L-k-2l}\left[2p(1-p)\right]^{k+2l}\right] \qquad (3)$$

The probability of the event $\{\hat{r} = r + k\}$ for $k = 0,1,.., $ (L - r) is given by:

$$\Pr(\hat{r} = r + k) = \sum_{l=0}^{r}\binom{r}{l}\binom{L-r}{k+l}\left[(1-p)^2 + p^2\right]^{L-k-2l}\left[2p(1-p)\right]^{k+2l} \qquad (4)$$

Using similar arguments, for m = 1,2,.., $r$ we have:

$$\Pr(\hat{r} = r - m) \cong \sum_{l=m}^{r} \binom{r}{l}\binom{L-r}{l-m}\left[(1-p)^2 + p^2\right]^{L-2l+m}\left[2p(1-p)\right]^{2l-m} \tag{5}$$

Before looking at the PMF of the random variable $\hat{r}$ in detail, consider the behavior of the PMF for small $p$. We consider $\hat{p} = \hat{r}/L$ which is the parameter of real interest to us. Note that for sufficiently small p, the only significant terms correspond to values $k = 0,1$ and $m = 1$, and the only significant contribution in the summations over $l$ in the above probability expressions is that due to $l = 0$ in (4) and $l = 1$ in (5).

$$\Pr(\hat{\rho} = \rho) \cong \left[(1-p)^2 + p^2\right]^L \cong \left[1 - 2Lp\right] \tag{6}$$

$$\Pr\left(\hat{\rho} = \rho - \frac{1}{L}\right) \cong r\left[(1-p)^2 + p^2\right]^{L-1}\left[2p(1-p)\right] \cong r\left[1 - 2(L-1)p\right]\left[2p(1-p)\right] \tag{7}$$

$$\Pr\left(\hat{\rho} = \rho - \frac{1}{L}\right) \cong (L-r)\left[(1-p)^2 + p^2\right]^{L-1}\left[2p(1-p)\right] \cong (L-r)\left[1 - 2(L-1)p\right]\left[2p(1-p)\right] \tag{8}$$

The variance of the estimate $\hat{p}$ based on the above approximation is given by:

$$\sigma^2 \cong \frac{\left[1 - 2(L-1)p\right]\left[2p(1-p)\right]}{L} \tag{9}$$

with the obvious assumption that $p < 1/[2(L-1)]$. Finally, for small values of $p$, we have:

$$\sigma^2 \cong \frac{2p}{L} - 4p^2 \tag{10}$$

where, now we require $p < 1/(2L)$. Note that this variance diminishes rapidly with decreasing $p$. To study the behavior of $\sigma$ as a function of $p$, let $p = 1/(2sL)$ where $s > 1$ is the parameter characterizing both $p$ and $\sigma$. In particular, with simple manipulation we get:

$$pL = \frac{1}{2s} \tag{11}$$

$$\sigma L = \sqrt{\frac{1}{s} - \frac{1}{s^2}} \tag{12}$$

Figure (2a) depicts the $\sigma L$ product versus the $pL$ product as $s$ varies from $s = 3$ to $s = 40$. The important observation is the rather gradual increase in $\sigma L$ as $pL$ is increased, which shows that the variance of the estimate of p tends to exhibit a saturating behavior. As an example of the use of this figure, at $pL = 0.1$ we have $\sigma L = 0.4$. Hence, for a block length of $L = 100$ we get that at $p = 10^{-3}$, $\sigma \approx 4 \times 10^{-3}$ which is indeed very small for any reasonable value of $p$

encountered in practice.

To confirm the general behavior observed above for larger values of ρ, we have evaluated the PMF of $\hat{p}$ for ρ in the range from ρ=0.1to ρ =0.9 for a block length of $L$ = 100. Two key observations from the results of our simulations are:

- the most probable value of $\hat{\rho}$, denoted M($\hat{\rho}$) (i.e., the Mode), obtained from evaluation of the empirical cross-correlation from noisy received vectors is not necessarily the true value ρ. This is particularly so at larger values of $p$ and for small and large values of ρ . Figure (2b) captures this behavior for two values of $p$ = 0.1 and $p$ = 0.01 as a function of $p$. In particular, this figure shows the difference (ρ-M($\hat{\rho}$)) versus ρ obtained from empirical evaluation of the cross-correlation from noisy received vectors;

- the standard deviation of $\hat{\rho}$ is independent of $p$ in the range ρ = 0.1 to ρ = 0.9 for a fixed value of $p$ as should be suspected. However, this standard deviation is a strong function of $p$ itself. Figure (2c) depicts the standard deviation of $\hat{\rho}$ as a function of $p$ for $L$ = 100. This figure is essentially the extension of the results depicted in figure (2a) to larger values ofp and reconfirms our observation that the standard deviation indeed increases slowly with increasing p. Note that even at values ofp as large asp = 0.3 this standard deviation is still relatively small for ρ in the range ρ = 0.1 to $p$ = 0.9.

While the above analysis has focused on short block length of L = 100, our experimental results suggest that similar conclusions also hold valid for larger values of L. The conclusion from the above passage is that the computation of the empirical cross-correlation between two received noisy vectors is relatively insensitive to the errors inflicting the two sequences even at rather large values of error probability p. Hence, the empirical cross-correlation between two sequences is *robust* to channel induced errors.

Next, a joint iterative decoding technique using the principles of the present invention for decoding correlated sources will now be described in more detail for an illustrative example.

In this section we present the proposed joint decoding algorithm for two correlated information sources. The extension to more sources is omitted at this stage for clarity of the presentation. In particular, as noted in the introduction, we assume two nodes A and B, such as the source 130, in a communication network have data to transmit to a given destination node C, such as the source 110. Let the two data sequences be represented by two packets of data which are correlated. The prevailing example we have referred to in this example is a DSN where the transmitting nodes are sensory nodes that are in close proximity to each other and may sample some environmental parameter of interest and wish to convey their information to their cluster head which in our model, represents the receiving node. In this scenario, it is relatively easy to envision the origin of correlation between data generated at distinct nodes. It should be appreciated that such correlation can indeed exist in a much more broader context within a communication network.

The individual source nodes A and B independently encode their data using simple convolutional codes and transmit the encoded data block over independent Additive White Gaussian Noise (AWGN) channels. At the receiver, the sufficient statistics for both sources are processed jointly. We note that aside from the fact the receiver may a-priori presume some correlation between the encoded received data might exist, no side information is communicated to the receiver. For one thing, no such side information can be generated by the individual sources without mutual communication. The receiver uses an iterative soft decision decoding technique for joint detection of the transmitted data sequences. Hence, the starting point in our development shall be the mathematical development behind joint soft decision decoding.

Let $Z$ be a random variable in Galois Field GF(2) assuming values from the set {+1, -1} with equal probability, where +1 is the "null" element under the modulo-2 addition. As explained in J. Hagenauer, E. Offer, and L. Papke, "Iterative decoding of binary block and convolutional codes," IEEE Trans. on Inform. Theory, vol.42, no.2, pp.429-445, March 1996, the log-likelihood ratio of a binary random variable Z is defined as

$$L_z(z) = \log\left[\frac{P_z(z=+1)}{P_z(z=-1)}\right]$$

where $P_z(z)$ is the probability that the random variable $Z$ takes on the value $z$. Under the modulo-2 addition, it is easy to prove that for statistically independent random variables $X$ and $Y$ the following relation is valid:

$$P(X \oplus Y = +1) = P(X = +1)P(Y = +1) + (1 - p(X = +1))(1 - p(Y = +1)) \qquad (13)$$

Hence, for $Z = X \oplus Y$:

$$P_z(z = +1) = \frac{e^{L_z(z)}}{1 + e^{L_z(z)}} \qquad (14)$$

Furthermore, the following approximation holds:

$$L_z(z) = \log\left[\frac{1 + e^{L_x(x)}e^{L_Y(y)}}{e^{L_x(x)} + e^{L_Y(y)}}\right] \approx sign(L_X(x)) \cdot sign(L_Y(y)) \cdot \min(|L_X(x)|, |L_Y(y)|) \qquad (15)$$

Soft decision joint iterative decoding of the received signals can best be described using an elementary decoding module denoted as the Soft-Input Soft-Output (SISO) decoder. The SISO decoder works at the symbol level following the Maximum A-posteriori Probability (MAP) decoding algorithm proposed by Bahl *et al* with some modifications with the goal of making the SISO unit operate on integer metrics (i.e., integer arithmetic as opposed to floating point arithmetic implementation). The decoder operates on the time-invariant trellis of a generic rate $R_o = \dfrac{p}{n}$ convolutional encoder.

Figure (3) schematically depicts a generic trellis section for such a code. In this figure, the trellis edge is denoted by e, and the information and code symbols associated with the edge e are denoted by x(e) and *c(e)* respectively. The starting and ending state of the edge *e* is identified by $s^S(e)$ and $s^E(e)$ respectively.

The SISO operates on a block of encoded data at a time. In order to simplify the notation, where not specified, x and y indicate blocks of data bits. Sequence x is composed of the bits $x_{k,t}$ for k = 1, ..., L and $t = 1,...,p$, where $\{\mathbf{x}_{k,t}\}_{k=1}^{L}$ is the t-th input sequence of the rate *p/n* code. A similar notation is used for the sequence *y*.

Furthermore, we shall formulate the metric evaluations for the received data associated with the first source and denoted by x only. This formulation obviously applies to the received data associated with the other source y as well. Let us denote the log-likelihood ratio associated with the information symbol *x* by *L(x)*. We use the following notation:

- $L^{(i)}(x;I)$ and $L^{(i)}(y;I)$ denote the log-likelihood ratios of the extrinsic information associated with the source symbols x and *y* at the input of the SISO decoders at iteration i;

- $L(c_1;I)$ and $L(c_2;I)$ denote the log-likelihood ratios of the encoded symbols coming from the channel at the input of the SISO decoders;

- $L^{(i)}(x;O)$ and $L^{(i)}(y;O)$ denote the extrinsic log-likelihood ratios related to the information symbols *x and y* at the output of the SISO decoders, evaluated under the code constraints at iteration i;

- $\hat{x}^{(i)}$ and $\hat{y}^{(i)}$ represents the hard estimates of the source symbols x and y at iteration *i*(i.e., the decoded symbols at iteration i).

Consider the channel encoder at the source receiving an input data block of L bits and generating an output data block of $L \cdot R_0^{-1}$ bits, whereby $R_0$ is the rate of the convolutional encoder. Let the input symbol to the convolutional encoder (for a generic rate *p/n* code) denoted $x_k(e)$ represent the input bits $x_{kj}$ with *j = 1,... ,p* on a trellis edge at *time k* (*k = 1,..., L*), and let the corresponding output symbol of the convolutional encoder $c_k(e)$ at time *k* be represented by the output bits $c_{k,j}(e)$ with j = 1,..., *n* and *k = 1,..., L*. Based on these assumptions, the log-likelihood ratios of the source bits $x_{k,j}$ can be evaluated for any *j = 1,... , P* by the SISO decoder at iteration *i* as follows:

$$L_k^{(i)}\left(x_{k,j};O\right) = \overset{\bullet}{\max}_{e:x_{k,j}(e)=1} \left\{ \alpha_{k-1}\left[s^S(e)\right] + \sum_{t=1,t\neq j}^{p} x_{x,t}(e)L_k^{(i)}\left[x_{k,t};I\right] + \right.$$

$$+ \sum_{t=1}^{n} c_{k,t}(e)L_k\left[c_{k,t};I\right] + \beta_k\left[s^E(e)\right] \left. \right\} +$$

$$- \overset{\bullet}{\max}_{e:x_{k,j}(e)=0} \left\{ \alpha_{k-1}\left[s^S(e)\right] + \sum_{t=1,t\neq j}^{p} x_{k,t}(e)L_k^{(i)}\left[x_{k,t};I\right] + \right.$$

$$+ \sum_{t=1}^{n} c_{k,t}(e)L_k\left[c_{k,t};I\right] + \beta_k\left[s^E(e)\right] \left. \right\}, \quad k = 1,\dots,L-1$$

where, the forward recursion at time $k$, $\alpha_k(.)$, as is shown in L. R. Bahl, J. Cocke, F. Jelinek, and J. Raviv, "Optimal decoding of linear codes for minimizing symbol error rate," IEEE Trans. On Inform. Theory, vol.IT-20, pp.284-287, May 1974, can be evaluated through:

$$\alpha_k(s) = h_{\alpha_k} + \overset{\bullet}{\max}_{e:s^E(e)=s} \left\{ \alpha_{k-1}\left[s^S(e)\right] + \sum_{t=1}^{p} x_{k,t}(e)L_k^{(i)}\left[x_{k,t};I\right] + \right.$$

$$+ \sum_{t=1}^{n} c_{k,t}(e)L_k\left[c_{k,t};I\right] \left. \right\}, \quad k = 1,\dots,L-1 \tag{16}$$

while, the backward recursion, $\beta_k(\cdot)$, can be evaluated through:

$$\beta_k(s) = h_{\beta_k} + \overset{\bullet}{\max}_{e:s^E(e)=s} \left\{ \beta_{k-1}\left[s^S(e)\right] + \sum_{t=1}^{p} x_{k+1,t}(e)L_{k-1}^{(i)}\left[x_{k+1,t};I\right] + \right.$$

$$+ \sum_{t=1}^{n} c_{k+1,t}(e)L_{k+1}\left[c_{k+1,t};I\right] \left. \right\}, \quad k = L-1, L-2,\dots,1 \tag{17}$$

To initialize the above recursions, the following are used:

$$\alpha_0(s) = \begin{cases} 0 & \text{if } s = S_0 \\ -\infty & \text{otherwise} \end{cases} \tag{18}$$

and

$$\beta_L(S_i) = \begin{cases} 0 & \text{if } s = S_L \\ -\infty & \text{otherwise} \end{cases} \tag{19}$$

where, So and $S_L$ are the initial and terminal states of the convolutional codes (assumed to be the all-zero state). The SISO module operates in the log-domain so that only summation of terms are needed. The operator max* above signifies the following:

$$\overset{\bullet}{\max}_i(a_i) = \log\left[\sum_{i=1}^{Q} e^{a_i}\right] = \max_i(a_i) + \delta\left(a_1,\dots,a_Q\right) \tag{20}$$

where, $\delta(a_1,..., a_Q)$ is a correction term that can be computed using a look-up table.

Finally, $h_{\alpha k}$ and $h_{\beta k}$ are two normalization constants that for a hardware implementation of the SISO are selected to prevent buffer overflows.

The bit decisions on the sequence $\hat{x}^{(i)}$ at iteration i can be obtained from the log-likelihood ratios of $x_{k,t}$, $\forall t = I,..., p$, $\forall k = I,...,L$ by computing:

$$L^{(i)}_{x_{k,t}} = L^{(i)}_k(x_{k,t};O) \qquad (21)$$

and making a hard decision on the sign of these metrics.

In the same way, the bit decisions on the sequence $\hat{y}^{(i)}$ at iteration i can be obtained from the log-likelihood ratios of $y_{k,t}$, $\forall t = 1,..., p$, $\forall k = 1,..., L$ by computing:

$$L^{(i)}_{y_{k,t}} = L^{(i)}_k(y_{k,t};O) \qquad (22)$$

and making a hard decision on the sign of these metrics.

The architecture of the joint channel decoder is depicted in Fig. (4). Let us elaborate on the signal processing involved. In particular, as before let $X$ and $Y$ be two correlated binary random variables which can take on the values $\{+1, -1\}$ and let $Z = X \oplus Y$. Let us assume that random variable $Z$ takes on the values $\{+1, -1\}$ with probabilities $P_z(z = +1) = p_z$ and $P_z(z = -1) = 1 - p_z$. Both sources independently from each other, encode the binary sequences x and y with a rate-$p/n$ convolutional encoder having memory v. For simplicity, let us consider a rate-1/2 convolutional encoder. Both encoded sequences are transmitted over independent AWGN channels. The received sequences $are$ $r_x$ and $r_y$ which take on values in $R^L$ (R is the set of real numbers) in the case the transmitted bits are encoded in blocks of length $L$. Let $N_o/2$ denote the double-sided noise-power spectral density and recall that $\sigma^2 = N_o/2$. With this setup, the log-likelihood ratios related to the observation samples $r_x$ at the output of the matched filter can be evaluated as follows:

$$L_k(c_{1,k};I) = \frac{2}{\sigma^2} r_{x_k}, \quad k = 1,...,L-1 \qquad (23)$$

In the same way, the log-likelihood ratios related to the observation samples $r_y$ at the output of the matched filter can be evaluated as follows:

$$L_k(c_{2,k};I) = \frac{2}{\sigma^2} r_{y_k}, \quad k = 1,...,L-1 \qquad (24)$$

The log-likelihood ratios $L^{(i)}_z(z)$ at iteration ($i$) are evaluated as follows:

$$L^{(i)}_z(z) = \log\left(\frac{1-p_{\hat{z}}}{p_{\hat{z}}}\right) \qquad (25)$$

by counting the number of places in which $\hat{x}^{(i)}$ and $\hat{y}^{(i)}$ differ, or equivalently by evaluating the Hamming weight $w_H(\cdot)$ of

the sequence $\hat{z}^{(i)} = \hat{x}^{(i)} \oplus \hat{y}^{(i)}$ whereby, in the previous equation, $p_{\hat{z}} = \dfrac{w_H(\hat{z}^{(i)})}{L}$. In the latter case, by assuming that the sequence $\vec{Z} = \vec{X} \oplus \vec{Y}$ is i.i.d., we have:

$$L_z^{(i)}(z) = \log\left(\frac{L - w_H\left(\hat{z}^{(i)}\right)}{w_H\left(\hat{z}^{(i)}\right)}\right) \qquad (26)$$

where L is the data block size.

Finally, applying equation (15) we can obtain an estimate of the extrinsic information on the source bits for the next iteration:

$$L^{(i)}(x;I) = L\left(\hat{z}^{(i-1)} \oplus \hat{y}^{(i)}\right) \qquad (27)$$

and

$$L^{(i)}(y;I) = L\left(\hat{z}^{(i-1)} \oplus \hat{x}^{(i)}\right) \qquad (28)$$

Note that as far as the LLR of the difference sequence

$$\vec{Z}$$

is concerned, a correlation of for instance 10% or 90% between $X$ and $Y$ carry the same *amount* of information. Hence, the performance gain of the iterative joint decoder in either case is really the same (we have verified this experimentally). That is what was meant when in the preceding text it is stated that coding gains can be obtained if the two sequences are either very similar (e.g., 90% correlated) or very different (e.g., 10% correlated). From an information theoretic point of view, all this says is that the entropy of the random variable Z is symmetric about the 50% correlation point. Formally, the joint decoding algorithm can be formalized as follows:

1. Set the iteration index $i = 0$ and set the log-likelihood ratios $L^{(0)}(x;I)$ and $L^{(0)}(y;I)$ to zero (see Fig.(4)). Compute the log-likelihood ratios for the channel outputs using equations (23) and (24) for both received sequences $r_x$ and $r_y$. Conduct a preliminary MAP decoding in order to obtain an estimate of both sequences $\hat{x}^{(0)}$ and $\hat{y}^{(0)}$ and evaluate $w_H(\hat{z}^{(0)}) = w_H(\hat{x}^{(0)} \oplus \hat{y}^{(0)})$. Use $w_H(\hat{z}^{(0)})$ to evaluate $L_z^{(0)}(z)$ in equation (26). Note that if the receiver already has an estimate of the correlation between the two transmitted sequences x and $y$ (i.e., with side information), it can directly evaluate equation (26). In our simulations, we do not assume the availability of any side information.

2. Set $L^{(i)}(x;I)$ and $L^{(i)}(y;I)$ to zero.

3. For iteration $i=1, ...,q,$ perform the following:

a) Make a MAP decoding for both received sequences $r_x$ and $r_y$ by using the log-likelihood ratios as expressed in equations (23) and (24).

b) Evaluate $L_z^{(i)}(z)$ using equations (26).

c) Evaluate $L^{(i)}(x;I)$ by using $L_z^{(i-1)}(z)$ and $L^{(i)}(y;O)$. Evaluate $L^{(i)}(y;I)$ by using $L_z^{(i-1)}(z)$ and $L^{(i)}(x;O)$.

d) Go back to (a) and continue until the last iteration $q$.

As it is possible to see from the algorithm, the joint decoder at any stage i estimates the extrinsic log-likelihood ratios $L^{(i)}$ $(x,-l)$ and $L^{(i)}$ $(y;l)$ by using the new estimates of the source bits $\hat{x}^{(i)}$ and $\hat{y}^{(i)}$ and the previous estimate on the difference sequence $\hat{z}^{(i-l)}$.

ANALYTICAL PERFORMANCE BOUNDS

In this section, our goal is to develop analytical bounds on the performance of the iterative joint channel decoder. We note that if iterative joint channel decoding is not performed, the performance of the individual links between transmitter A and receiver C and transmitter B and receiver C, *are* essentially dominated by the performance of the individual convolutional codes used for channel coding.

Upper-bounds on the performance of convolutional codes based on well-known transfer functions or based on the knowledge of the distance spectrum of the code are readily available. In practice, we may use the knowledge of the first few lowest distance terms of the distance spectrum of a given convolutional code to obtain a reasonable approximation to the asymptotic performance of the code using union bounding technique. This asymptotic performance is achieved at sufficiently high SNR values.

It is known that for soft-decision Viterbi decoding, the BER of a convolutional code of rate $R_0 = \dfrac{p}{n}$ with BPSK or QPSK modulation in AWGN, can be well upper-bounded by the following expression:

$$P_b \leq \frac{1}{p} \sum_{d=d_{free}}^{\infty} w_d Q\left( \sqrt{2\frac{E_b}{N_0} R_0 d} \right) \tag{29}$$

in which $d_{free}$ is the minimum non-zero Hamming distance of the Convolutional Code (CC), $w_d$ is the cumulative Hamming weight (for the information bits) associated with all the paths that diverge from the correct path in the trellis of the code, and re-emerge with it later and are at Hamming distance d from the correct path, and finally Q(.) is the Gaussian integral function, defined as

$$Q(t_0) = \frac{1}{\sqrt{2\pi}} \int_0^{\infty} e^{-\frac{t^2}{2}} dt$$

Similarly, it is possible to obtain an upper-bound on the FER of the code as follows:

$$P_f \leq \sum_{d=d_{free}}^{\infty} m_d Q\left( \sqrt{2\frac{E_b}{N_0} R_0 d} \right) \tag{30}$$

where, $m_d$ is the multiplicity of all the paths that diverge from the correct path in the trellis of the code and re-emerge with it later and are at Hamming distance d from the correct path.

*A. Genie Aided Lower-Bound*

A simple lower-bound on the performance of the iterative joint channel decoder for correlated sources can be obtained by shifting the BER or FER curve of the individual convolutional codes to the left by an amount of 10 log(2) = 3 *dB*. The justification for the bound is simple. If a genie was available at the receiver that would tell it simply in which locations the data transmitted by A and B where identical and in which locations they were different (assuming BPSK transmission for simplicity), then the receiver prior to decoding, would combine the signals coherently and effectively double the received SNR. This doubling of the receiver input SNR corresponds to 3 *dB* of gain. In general for *M* correlated sources, the Genie aided SNR gain would be 10 log(*M*).

The performance of the channel decoding technique described above may be estimated as follows.

*B. Performance Bound for Joint Channel Decoding of Correlated Sources*

Hagenauer provides the theoretical development for the performance bound of the Viterbi Algorithm (VA) with a-priori soft information. The performance of the Viterbi decoder with a-priori soft information is essentially the same as the performance of the SISO decoder employing one iteration of the forward-backward algorithm with the same a-priori soft information. Hence, the result can be directly used to provide an upper-bound on the performance of the iterative joint channel decoder for correlated sources.

We shall first provide a setup for using the Hagenauer bound in the current context, and subsequently provide the bound itself. In particular, suppose the receiver has the exact knowledge of the correlation coefficient between the data transmitted by *A* and *B* (note that this is much weaker than knowing where the two sequences differ). As noted before, at sufficiently high SNR where union type bounds have validity, the estimate of the cross correlation at the decoder from the noisy received vectors is actually quite good. Hence, the upper-bound to the performance of the decoder that knows the actual value of the cross-correlation is reasonably close to the upper-bound on the performance of the actual decoder. Assuming that the SNR per link between A and C, and B and C are the same, the independence of the channel noise inflicting the two transmitted data packets suggests that to a first order approximation, the error positions for the decoded data packet x and for the decoded data packet y are independent. This suggests that the BER of the data sequence z is almost twice the BER of the data sequences *x* and *y*. Hence, an upper-bound on the BER of the sequence *z* provides an upper-bound on the BER of sequences *x* and *y*. The exact knowledge of the cross correlation coefficient is equivalent to knowing the a-priori probability of the bits associated with the sequence *z,* hence, the exact knowledge of the a-priori LLR on sequence z. Since the CC is linear, the difference sequence *z = x ⊕ y* when encoded, produces a valid codeword that is in the code space. Hence, we can envision the sequence *z* being encoded by the same CC that encodes sequences *x* and *y* and subsequently find an upper-bound on the performance of the Viterbi decoder with a-priori soft information derived from the knowledge of the correlation coefficient. The resulting upper-bound can then be used to provide an upper-bound on the BER of the transmitted sequences x and *y* decoded by the actual iterative joint channel decoder.

While we anticipate that the BER of sequence z to be twice the BER of sequences x and y, any error present in sequence z corresponds to a frame error either in sequence a; or y or both. In the worst case, a frame error on sequence z, corresponds to frame errors on both sequences x and *y.* Hence, we can take as the upper-bound on the FER of sequence x or y, the upper-bound on the FER of the sequence z.

The Hagenauer bound with the LLR associated with sequence Z denoted $L(Z) = \log\left(\dfrac{\rho}{1-\rho}\right)$ is given by:

$$P_b \le \frac{1}{p} \sum_{d=d_{free}}^{\infty} w_d Q\left(\sqrt{2\frac{E_b}{N_0} R_0 d\left(1 + \frac{w_d}{m_d} \frac{L(Z)}{4dR_o E_b/N_0}\right)^2}\right) \tag{31}$$

where, $m_d$ is the multiplicity of all the paths that diverge from the correct path in the trellis of the code and re-emerge with it later and are at Hamming distance *d* from the correct path and $w_d$ is the cumulative Hamming weight (for the information bits) associated with all the paths that diverge from the correct path in the trellis of the code, and re-emerge with it later and are at Hamming distance d from the correct path. This bound is essentially identical to the bound expressed in prior art disclosures except for the correction factor that accounts for the a-priori information on Z.

In order to more clearly demonstrate the performance of the joint soft decoding algorithm in accordance with the present invention, the following simulations have been performed.

We have simulated the performance of our proposed iterative joint channel decoding of correlated sources assuming simple convolutional encoding at the sources. We assume that our transmit nodes use the same convolutional codes and the SNR of each of the two received sequences are the same.

The convolutional codes used in our simulations are among the best codes for a given memory and rate (and hence decoding complexity), ever reported in the literature. The generator matrices of the rate 1/2 encoders using the delay operator notation D are:

- 4-state non-recursive, non-systematic encoder ⇒ $G(D)=[1 + D^2, 1 + D + D^2]$
- 8-state non-recursive, non-systematic encoder ⇒ $G(D) = [1 + D + D^3, 1 + D + D^2 + D^3]$;
- 16-state non-recursive, non-systematic encoder ⇒ $G(D) = [1 + D^3 + D^4, 1 + D + D^2 + D^4]$.

We have verified by simulations that there is essentially no difference between using systematic or non-systematic and recursive or non-recursive encoders, hence, we opted for the codes listed above and SISO decoders for these codes were generated.

The simulation results are reported as follows:

1) Figures (5a), (5b) and (5c) show the BER of either the data sequence $x$ or $y$ (the BER on these two sequences coincide; at a given iteration, $SISO_1$ refers to the BER of sequence $x$ while $SISO_2$ refers to the BER of sequence y) encoded by the 4-state code above as a function of SNR, for varying degrees of cross-correlation $\rho$ between the sources, when the sequences are decoded by the proposed iterative joint channel decoder. Several observations are in order:

   a) the performance curves for cross-correlation $\rho$ and $(1 - \rho)$ are identical. As noted before, this symmetry is expected in light of the symmetry of the entropy function about $\rho = 0.5$;

   b) 3- or 4-iterations suffice to get almost all that can be gained from the knowledge of the cross-correlation. We note that our comparison of the simulation results with the analytical performance bounds presented below, reinforce this statement;

   c) since the estimates of the cross-correlation are noisy at sufficiently low SNR levels, decoding iterations are critical for improving performance, otherwise 2-iterations are often sufficient to obtain most of the achievable gain;

   d) as the cross-correlation approaches 0.5, the achievable gains diminish as expected and reduces to zero at $\rho = 0.5$. This implies that when the two sequences are totally uncorrelated (according to our definition), the performance of the iterative joint channel decoder is no better than the case each received sequence is independently decoded. On the other hand, when the cross-correlation level is nearly one or zero, the achievable coding gain is a function of the operating BER and diminishes as BER decreases. Note that the four state code with a value of $\rho$ close to one achieves 2.1 dB of coding gain at 0 dB of SNR. This is astonishing given that the gap between the performance of the iterative joint decoder and the Genie aided lower-bound, is only 0.9 dB.

2) Figures (5d), (5e) and (5f) show the BER as a function of SNR and $\rho$ at the end of four decoding iterations, for the 4-state, 8-state and 16-state convolutional codes respectively (the code generators are provided above). The main observation from these figures is that the coding gain of the iterative joint channel decoder does not seem to depend on the code memory, rather, it is a strong function of the degree of correlation between the sequences as should be expected.

Finally, figures (5g) and (5h) provide a comparison of the performance of the iterative joint channel decoder to the analytical upper-bound derived above, for the 4-state and 8-state codes at two values of L(z) specified in the figures. The value *of L(z)* = 0 corresponds to the case $\rho = 0.5$ and hence, there is no a-priori information available to the joint decoder to improve performance. In general, union type upper-bounds as reported in the figures are loose at low values of SNR, and asymptotically tight at sufficiently high SNR values. The gap between the simulated performance and the upper-bounds at high SNR values is largely due to the fact that we have implemented the SISO decoders using integer arithmetic. This naturally results in some loss in performance, otherwise the performance of the iterative joint decoder almost coincides with the analytical upper-bound in high SNR regimes, suggesting that at least asymptotically, the decoder is close to optimal.

As a result, soft information may be generated at the receiver associated with the cross-correlation between two sequences during decoding iterations and this information may be used to improve the decoder performance.

In an illustrative embodiment, serially concatenated convolutional codes (SCCC) are used for channel encoding of multiple correlated sources. In this embodiment, although the present invention is applicable to any number of correlated sources, two correlated sources are provided that transmit SCCC encoded data to a single destination receiver. As before, any channel side information is neither assumed nor used at the receiver. As before, empirical cross-correlation measurements at successive decoding iterations are employed to provide extrinsic information to the outer codes of the SCCC configuration.

Two levels of soft metric iterative decoding are used at the receiver: 1) iterative Maximum A-posteriori Probability (MAP) decoding is used for efficient decoding of individual SCCC codes (local iterations) and 2) iterative extrinsic information feedback generated from the estimates of the empirical cross-correlation in partial decoding steps is used to pass soft information to the outer decoders of the global joint SCCC decoder (global iterations). Later on, simulation results for iterative joint SCCC decoding of correlated sources for a data packet size of L=320 will be provided. Representative results associated with the estimation of the correlation for this block length are as follows:

1) The PMF of $\hat{\rho}$ for three different values of raw error rate p when the true cross-correlation between the data packets is *p* = 0.8 at an example data block length of *L* = 320 has been evaluated. The following observations are in order: a) there is a bias in the empirical estimate of $\rho$ as measured between the most probable value of $\hat{\rho}$ and the true value of *p* which is a strong function *of p,* b) at a value of p = 0.316 (representative of high raw error rate occurring at low values of SNR), there is a non-zero probability that $\hat{\rho}$ < 0.5 implying that such cross-correlation information when used by the iterative decoder may actually *increase* the error rate. Fortunately, for the majority of the received data packets $\hat{\rho}$> 0.5 and cross-correlation feedback actually improves performance. Simulation results shown later suggest that for the majority of the data frames, the cross-correlation feedback reduces the error rate, while for a very small number of data packets, the error rate increases. The net effect is often such that the overall BER actually decreases even at very low SNR values, and c) as expected, the variance of the estimate diminishes rapidly and the bias is reduced as p decreases.

2) As noted above, the most probable value of $\hat{\rho}$, denoted $M(\hat{\rho})$ (i.e., the Mode), obtained from evaluation of the empirical cross-correlation from noisy received vectors is not necessarily the true value *p*. This is particularly so at larger values of $\rho$ and for small and large values of *p*.

3) The standard deviation of $\hat{\rho}$ is independent *of* $\rho$ in the range *p* = 0.1 to *p* = 0.9 for a fixed value of *p* as should be suspected. However, this standard deviation is a strong function *of p* itself. The standard deviation of $\hat{\rho}$ as a function *of p* for *L* = 320 (a representative value) has been evaluated. Analysis shows that the standard deviation indeed increases slowly with increasing p. Note that even at values *of p* as large as *p = 0.3* this standard deviation is still relatively small *for* $\rho$ in the range $\rho$ = 0.1 to $\rho$ = 0.9.

While the above analysis has focused on short block length of L = 320, our experimental results suggest that similar conclusions also hold valid for larger values of L. In assessing how large a value of L can be used, what is more critical is the performance of the iterative decoder. The conclusion from the above passage is that the computation of the empirical cross-correlation between two received noisy vectors is relatively insensitive to the errors inflicting the two sequences even at rather large values of error probability p. Hence, the empirical cross-correlation between two sequences is *robust* to channel induced errors.

The joint iterative decoding of SCCC encoded correlated sources may be performed in the following way.

Let the two data sequences be represented by two packets of data x and y which are correlated. The individual source nodes A and B independently encode their data using serially concatenated convolutional codes and transmit the encoded data block over independent Additive White Gaussian Noise (AWGN) channels. At the receiver, the sufficient statistics for both sources are processed jointly. We note that aside from the fact the receiver may a-priori presume some correlation between the encoded received data might exist, no side information is communicated to the receiver. The receiver uses an iterative soft decision decoding technique for joint detection of the transmitted data sequences. Hence, the starting point in our development shall be the mathematical equations needed for joint soft decision decoding.

Let Z be a random variable in Galois Field $GF_2$ assuming values from the set {+1, -1} with equal probability, where +1 is the "null" element under the modulo-2 addition. As explained in J. Hagenauer, E. Offer, and L. Papke, "Iterative decoding of binary block and convolutional codes," IEEE Trans. on Inform. Theory, vol.42, no.2, pp.429-445, March 1996, the log-likelihood ratio of a binary random variable Z is defined as $L_z$ (z) = $\log\left[\dfrac{P_z(z=+1)}{P_z(z=-1)}\right]$, where

$P_z$(z) is the probability that the random variable Z takes on the value z. Under the modulo-2 addition, it is easy to prove that for statistically independent random variables *X* and *Y* the following relation is valid:

$$P(X \oplus Y = +1) = P(X = +1)P(Y = +1) + \\ + (1 - p(X = +1))(1 - p(Y = +1)) \tag{32}$$

Hence, for *Z = X* $\oplus$ *Y :*

$$P_z(z = +1) = \frac{e^{L_z(z)}}{1 + e^{L_z(z)}} \tag{33}$$

Furthermore, the following approximation holds:

$$L_z(z) = \log\left[\frac{1 + e^{L_x(x)}e^{L_Y(y)}}{e^{L_x(x)} + e^{L_Y(y)}}\right] \approx$$
$$\approx sign(L_X(x)) \cdot sign(L_Y(y)) \cdot \min(|L_X(x)|, |L_Y(y)|)$$

(34)

Soft decision joint iterative decoding of the received signals can best be described after having described the SCCC decoder shown in Fig.(6). The SCCC decoder works at the bit level employing Soft-In Soft-Out (SISO) elementary modules following the decoding algorithm proposed with some modifications according to known techniques to use integer arithmetic. In order to keep the presentation concise, we will only deal with the modifications made to the SCCC decoder in comparison to the standard decoder.

In the classic SCCC decoder, at any decoding iteration the outer SISO decoding module receives the Log-Likelihood Ratios (LLRs) $L(c; I)$ of its code symbols from the inner SISO, while always setting the extrinsic information $L^{(i)}(x;I)$ to zero because of the assumption that the transmitted source information symbols are equally likely. In our setup, the joint iterative decoding algorithm is able to estimate the LLRs $L^{(i)}(x;I)$ using cross-correlation information and to pass on this information to the outer SISO decoding module during the iterations of the SCCC decoder. Because of this fact, the outer SISO decoder should be modified in order to account for the non-zero $L^{(i)}(x;I)$ values. Let us focus only on these modifications, by omitting the details of the inner SISO decoder for which the interested reader can refer to prior art disclosures for additional details.

The outer SISO decoder operates on the time-invariant trellis of a generic rate $R_o$ = 1/2 convolutional encoder (the code rate can be different, since in simulations we have used rate 1/2 codes, we make reference to this code rate). Again Figure (3) depicts a generic trellis section for such a code. In this figure, the trellis edge is denoted by e, and the information and code symbols associated with the edge e are denoted by x(e) and c(e) respectively. The starting and ending states of the edge e are identified by $s^S(e)$ and $s^E(e)$ respectively.

The SISO operates on a block of encoded bits at a time. In order to simplify the notation, where not specified, x and y indicate blocks of data bits. Sequence x is composed of the bits $X_k$ for k = 1,..., L. A similar notation is used for the sequence y produced by the other source. Furthermore, we shall formulate the metric evaluations for the received data associated with the first source and denoted by x only. This formulation obviously applies to the received data associated with the other source y as well. Let us denote the log-likelihood ratio associated with the information symbol x by $L(x)$, We use the following notation, as is illustrated in figure (6). Figure (4) shows the structure of the global decoder when the following modifications are applied to the figure: a) replace $L(c_1;I)$ and $L(c_2;I)$ by $L(c_1^{inn};I)$ and $L(c_2^{inn};I)$, and b) replace the *MAP decoder* block, by *SCCC decoder* block whose internal structure is shown in Fig. (6) :

- $L^{(i)}(x;I)$ denotes the log-likelihood ratios of the extrinsic information associated with the source bits x at the input of the outer SISO decoder at iteration i of the proposed joint decoding algorithm which shall be presented shortly. Iteration index *i* is a *global iteration* index. The decoding of each SCCC encoded sequence itself requires a number of *local iterations* whose index is hidden for now for simplicity;
- $L(c; I)$ denotes the log-likelihood ratios of the code bits coming from the inner SISO decoder after the application of the inverse permutation $\Pi$;
- $L(c^{inn};I)$ denotes the log-likelihood ratios of the coded symbols $c^{inn}$ at the output of the matched filter corresponding to the sufficient statistics from the channel;
- $L(x; 0)$ denotes the extrinsic log-likelihood ratios related to the information bits *x* at the output of the outer SISO decoder, evaluated under the code constraints imposed by the outer code;
- $\hat{x}$ represents the hard estimates of the source bits x (i.e., the decoded bits after a predefined number of iterations at the output of the SCCC decoders).

It is again referred to the SCCC decoder shown in Fig. (6). The outer encoder at the source receives an input data block of *L* bits and generates an output data block of $L \cdot R_o^{-1}$ bits, whereby $R_o$ is the rate of the outer convolutional encoder. It is also evident that the product $L \cdot R_o^{-1}$ corresponds to the size of the interleaver embedded in the SCCC (there is a small difference in the actual size due to trellis termination of the outer encoder).

Let the input bit to the convolutional encoder (for a rate 1/2 code) denoted $x_k$ (e) represent the input bits $X_k$ on a trellis edge at time *k* (k = 1,..., L), and let the corresponding output symbol of the convolutional encoder $C_k$(e) at time k be represented by the output bits $c_{k,t}$(e) with *t* = 1,2 and *k* = 1,..., L. Based on these assumptions, the log-likelihood ratios of the source bits $X_k$ can be evaluated by the outer SISO decoder at local iteration *j* of the SCCC as follows:

$$L_k^{(j)}(x_k;O) = \overset{\bullet}{\underset{e:x_k(e)=1}{\max}} \left\{ \alpha_{k-1}\left[s^S(e)\right] + \sum_{t=1}^{2} c_{k,t}(e) L_k\left[c_{k,t};I\right] + \beta_k\left[s^E(e)\right] \right\} +$$

$$- \overset{\bullet}{\underset{e:x_k(e)=0}{\max}} \left\{ \alpha_{k-1}\left[s^S(e)\right] + \sum_{t=1}^{2} c_{k,t}(e) L_k\left[c_{k,t};I\right] + \beta_k\left[s^E(e)\right] \right\}, \quad k=1,...,L \qquad (35)$$

where, the forward recursion at time k, $a_k(.)$(see, for instance, L. R. Bahl, J. Cocke, F. Jelinek, and J. Raviv, "Optimal decoding of linear codes for minimizing symbol error rate," IEEE Trans. On Inform. Theory, vol.IT-20, pp.284-287, May 1974)
can be evaluated through:

$$\alpha_k(s) = \overset{\bullet}{\underset{e:x_k(e)=s}{\max}} \left\{ \alpha_{k-1}\left[s^S(e)\right] + x_k(e) L_k^{(i)}\left[x_{k,t};I\right] + \right.$$

$$\left. + \sum_{t=1}^{2} c_{k,t}(e) L_k\left[c_{k,t};I\right] \right\} + h_{\alpha_k}, \quad k=1,...,L-1 \qquad (36)$$

while, the backward recursion, $\beta_k(\cdot)$, can be evaluated through:

$$\beta_k(s) = \overset{\bullet}{\underset{e:x_k(e)=s}{\max}} \left\{ \beta_{k+1}\left[s^E(e)\right] + x_{k+1}(e) L_{k+1}^{(i)}\left[x_{k+1,t};I\right] + \right.$$

$$\left. + \sum_{t=1}^{2} c_{k+1,t}(e) L_{k+1}\left[c_{k+1,t};I\right] \right\} + h_{\beta_k}, \quad k=L-1,L-2,...,1 \qquad (37)$$

To initialize the above recursions, the following are used:

$$\alpha_0(s) = \begin{cases} 0 & if\ s=S_0 \\ -\infty & otherwise \end{cases} \qquad (38)$$

and

$$\beta_L(S_i) = \begin{cases} 0 & if\ s=S_L \\ -\infty & otherwise \end{cases} \qquad (39)$$

where. $S_o$ and $S_L$ are the initial and terminal states of the convolutional codes (assumed to be the all-zero state). The SISO module operates in the log-domain so that only summation of terms are needed.
The operator max* above signifies the following:

$$\overset{\bullet}{\max_i}(a_i) = \log\left[\sum_{i=1}^{Q} e^{a_i}\right] = \max_i(a_i) + \delta(a_1,...,a_Q) \qquad (40)$$

where, $\delta(a_1,..., a_Q)$ is a correction term that can be computed using a look-up table.
Finally, $h_{\alpha k}$ and $h_{\beta k}$ are two normalization constants that for a hardware implementation of the SISO are selected to prevent buffer overflows.
The bit decisions on the sequence $\hat{x}^{(i)}$ at local iteration $j$ can be obtained from the log-likelihood ratios of $x_k$,

$\forall k = 1,..., L$ by computing:

$$L_{x_k}^{(j)} = L_k^{(j)}(x_k; O) + L_k^{(i)}(x_k; I) \qquad (41)$$

and making a hard decision on the sign of these metrics.

In the same way, the bit decisions on the sequence $\hat{y}^{(j)}$ at iteration $j$ can be obtained from the log-likelihood ratios of $y_k$, $\forall k = 1,...,L$ by computing:

$$L_{y_k}^{(j)} = L_k^{(j)}(y_k; O) + L_k^{(i)}(y_k; I) \qquad (42)$$

and making a hard decision on the sign of these metrics.

The architecture of the global joint channel decoder is depicted in Fig. (4) where the following modifications should be applied to the figure: a) replace $L(c_1;I)$ and $L(c_2;I)$ by $L(c_1^{inn};I)$ and $L(c_2^{inn};I)$, and b) replace the *MAP decoder* block, by *SCCC decoder* block whose internal structure is shown in Fig. (6). Let us elaborate on the signal processing involved. In particular, as before let $X$ and Y be two correlated binary random variables which can take on the values {+1,-1} and let $Z = X \oplus Y$. Let us assume that random variable Z takes on the values {+1, -1} with probabilities $P_z(z = +1) = p_z$ and $P_z(z = -1) = 1 - p_z$.

Both sources independently from each other, encode the binary sequences $x$ and $y$ with a rate-$R_s$ SCCC. For simplicity, let us consider a rate-1/4 SCCC constituted by the serial concatenation of two rate-1/2 convolutional codes. Both encoded sequences are transmitted over independent AWGN channels. The received sequences are $r_x$ and $r_y$ which take on values in $\mathfrak{R}^{L \cdot R_s^{-1}}$ ($\mathfrak{R}$ is the set of real numbers) in the case the transmitted bits are encoded in blocks of length L. For each sequence index k, there are $R_s^{-1}$ received statistics that are processed by the decoder. Hence, to each information symbol $x_k$, we associate $r_{x_{k,t}}$, $t = 1,2,..., R_s^{-1}$ received statistics. Let $N_0/2$ denote the double-sided noise-power spectral density and recall that $\sigma_n^2 = N_0/2$. With this setup, the log-likelihood ratios related to the observation samples $r_x$ at the output of the matched filter can be evaluated as follows:

$$L_k\left(c_{1,k}^{inn}; I\right) = \frac{2}{\sigma_n^2} r_{x_{k,t}}, \quad k = 1,...,L, \quad t = 1,2,...,R_s^{-1} \qquad (43)$$

In the same way, the log-likelihood ratios related to the observation samples $r_y$ at the output of the matched filter can be evaluated as follows:

$$L_k\left(c_{2,k}^{inn}; I\right) = \frac{2}{\sigma_n^2} r_{y_{k,t}}, \quad k = 1,...,L, \quad t = 1,2,...,R_s^{-1} \qquad (44)$$

The log-likelihood ratios $L_z^{(i)}(z)$ at iteration (i) are evaluated as follows:

$$L_z^{(i)}(z) = \log\left(\frac{1 - p_{\hat{z}}}{p_{\hat{z}}}\right) \qquad (45)$$

by counting the number of places in which $\hat{x}^{(i)}$ and $\hat{y}^{(i)}$ differ, or equivalently by evaluating the Hamming weight $w_H(.)$ of

the sequence $\hat{z}^{(i)} = \hat{x}^{(i)} \oplus \hat{y}^{(i)}$ whereby, in the previous equation, $p_i = \dfrac{w_H\left(\hat{z}^{(i)}\right)}{L}$. In the latter case, by assuming that the sequence $\vec{Z} = \vec{X} \oplus \vec{Y}$ is i.i.d., we have:

$$L_z^{(i)}(z) = \log\left(\frac{L - w_H\left(\hat{z}^{(i)}\right)}{w_H\left(\hat{z}^{(i)}\right)}\right) \tag{46}$$

where L is the data block size. Finally, applying equation (34) we can obtain an estimate of the extrinsic information on the source bits for the next iteration:

$$L^{(i)}(x;I) = L\left(\hat{z}^{(i-1)} \oplus \hat{y}^{(i)}\right) \tag{47}$$

and

$$L^{(i)}(y;I) = L\left(\hat{z}^{(i-1)} \oplus \hat{x}^{(i)}\right) \tag{48}$$

Note that as far as the LLR of the difference sequence $z$ is concerned, a correlation of for instance 10% or 90% between $x$ and $y$ carry the same *amount* of information. Hence, the performance gain of the iterative joint decoder in either case is really the same (we have verified this experimentally). From an information theoretic point of view, all this says is that the entropy of the random variable Z is symmetric about the 50% correlation point.

Formally, the joint decoding algorithm can be formalized as follows:

1) Set the iteration index $i = 0$ and set the log-likelihood ratios $L^{(0)}(x;I)$ and $L^{(0)}(y;I)$ to zero (see Fig.(6)). Compute the log-likelihood ratios for the channel outputs using equations (43) and (44) for both received sequences $r_x$ and $r_y$. Conduct a preliminary set of iterations of each SCCC decoder in order to obtain an estimate of both sequences

$\hat{x}^{(0)}$ and $\hat{y}^{(0)}$ and evaluate $w_H(\hat{z}^{(0)}) = w_H(\hat{x}^{(0)} \oplus \hat{y}^{(0)})$. Use $w_H(\hat{z}^{(0)})$ to evaluate $L_z^{(0)}(z)$ in equation (46). Note that if the receiver already has an estimate of the correlation between the two transmitted sequences x and y (i.e., with side information), it can directly evaluate equation (46). In our simulations, we do not assume the availability of any side information.

4. Set $L^{(1)}(x;I)$ and $L^{(1)}(y;I)$ to zero.

5. For iteration $i=I,...,q,$ perform the following:

a) Make a predefined total number of iterations of the SCCC decoder for both received sequences $r_x$ and $r_y$ by using the log-likelihood ratios as expressed in equations (43) and (44).

b) Evaluate $L_z^{(i)}(z)$ using equations (46).

c) Evaluate $L^{(i)}(x;I)$ by using $L_z^{(i-1)}(z)$ and $L^{(i)}(y;O)$. Evaluate $L^{(i)}(y;I)$ by using $L_z^{(i-1)}(z)$ and $L^{(i)}(x;O)$.

d) Go back to (a) and continue until the last iteration q.

As it is possible to see from the algorithm, the joint decoder at any global iteration $i$ estimates the extrinsic log-likelihood ratios $L^{(i)}(x;I)$ and $L^{(i)}(y;I)$ by using the new estimates of the source bits $\hat{x}^{(i)}$ and $\hat{y}^{(i)}$ and the previous estimate on the difference sequence $\hat{z}^{(i-1)}$ (note that LLRs $L^{(i)}(x;I)$ and $L^{(i)}(y;I)$ are supplied to the outer decoder in the respective SCCCs).

Note that there is no need for subtracting the available a-priori information (e.g., from the previous iteration), from one global iteration to the next. Looking at the SCCC decoder for one of the two sources at a given global iteration, the updated estimate of the cross-correlation is used to generate a-priori soft information on the source bits that are combined with the intrinsic information derived from the channel to restart a sequence of local decoding iterations in the SCCC decoder. On the other hand, extrinsic information generated by a given block at iteration *(p-1)* within the SCCC iterative decoding loop must be subtracted at iteration *p* for proper processing.

We have conducted simulations of the proposed iterative joint channel decoder for correlated sources to verify functionality and assess the potential gains of the approach. A sample simulation result for a rate-1/4 SCCC obtained from a serial concatenation of an outer encoder with generator matrix $G(D) = \left[1, \dfrac{1 + D + D^3 + D^4}{1 + D + D^4}\right]$ and an inner

encoder with generator matrix $G(D) = \left[1, \dfrac{1 - D^2}{1 + D + D^2}\right]$ and employing a spread-25 Fragouli/Wesel interleaver of length 640 (see for instance: C. Fragouli and R.D. Wesel, "Semi-random interleaver design criteria," Proc. IEEE Globecom 1999, vol.5 , pp.2352-2356, Dec. 1999) is shown in Fig. (7a). In the figure, we show the BER and FER performance on the individual SCCCs (without joint decoding) after 35 iterations for comparison purposes. We have verified that more than 35 iterations did not yield further performance improvement of the individual SCCC BER and FER. In the same figure we show the performance of the proposed iterative joint channel decoder after 5 global iterations of the proposed algorithm whereby during each global iteration 10 local iterations of the individual SCCCs have been conducted using MAX*-Log-MAP algorithm with 3-bit quantization as specified in G. Montorsi and S. Benedetto, "Design of fixed-point iterative decoders for concatenated codes with interleavers," IEEE Journal on Selected Areas in Communications, Vo1.19, No.5, pp.871-882, May 2001. The simulation results reflect the performance of the iterative joint decoder for various correlation coefficients between the two sequences. All simulations have been conducted by counting 100 erroneous frames. The assumed modulation format is BPSK. The number of the preliminary iterations to initialize the global iteration was set to 12. To have an idea of the maximum achievable performance of the proposed algorithm, we show the performance in the case of 100% correlation existing between the two sequences (i.e., the case in which the two sequences are identical).

To see the impact of global iterations, simulation results shown in Fig. (7b) refer to the same rate-1/4 SCCC as above and depict the performance of the iterative joint decoder as a function of the number of global iterations. In the figure, we show the BER of the individual SCCCs after 35 iterations without iterative joint decoding, and with 2,5,9 and 13 global iterations of the proposed decoder, during each one of which, 3 local iterations of MAX*-Log-MAP algorithm have been applied for decoding of the individual SCCC codes. The simulation results are for a reference correlation coefficient of 70%. The number of the preliminary iterations to initialize the global iterations was set to 12.

To verify some of the theoretical results in connection with the estimation of the cross-correlation coefficient in the case of real decoding (recall that we assumed the error sequences were i.i.d in our analysis, and this is clearly not the case during actual joint decoding of the SCCC codes), we have compiled data from several simulation runs on the same SCCC codes as above employing the iterative joint decoder and have generated several empirical curves. In particular, Fig. (7c) shows the estimated $\rho$ at the end of the final global decoding iteration as a function of SNR $E_b/N_0$ for various block lengths and various degrees of correlation between the data generated by the correlated sources. Note the dependence of the estimate on SNR and the data block length and the existence of the bias all of which were predicted by the theoretical analysis. Finally, Fig. (7d) depicts the variance of the estimate of $\rho$ at the and of the final global decoding iteration as a function of SNR $E_b/N_0$ for various block lengths and various degrees of correlation between the data generated by the correlated sources. Once again the dependence of the variance on SNR and the data block length was correctly predicted by the simplified theoretical analysis.

JOINT ITERATIVE LDPC-DECODING OF CORRELATED SOURCES

Let the two data sequences be represented by two packets of data which are correlated. The individual source nodes A and B independently encode their data using LDPC codes and transmit the encoded data block over independent Additive White Gaussian Noise (AWGN) channels. At the receiver, the sufficient statistics for both sources are processed jointly. We note that aside from the fact the receiver may a-priori presume some correlation between the encoded received data might exist, no side information is communicated to the receiver.

In what follows, we shall briefly review the sum-product algorithm in order to highlight the way in which the extrinsic information can be exploited by the LDPC decoder in a joint decoding paradigm. For the sake of exploiting the extrinsic information in the LDPC decoder, the LDPC matrix for encoding each source is considered as a systematic (*n*, *k*) code. Each codeword c is composed of a systematic part u and a parity part $p_u$, which together form c=[u, Pu]. With this setup and given parity check matrix $H^{n-k,n}$ of the LDPC code, it is possible to decompose $H^{n-k-n}$ as follows:

$$H^{n-k,n} = \left(H^u, H^{p_u}\right) \qquad (49)$$

whereby, H" is a *(n - k)x (k)* matrix specifying the source bits participating in check equations, and $H^{p_\cdot}$ is a *(n - k)x (n - k)* matrix of the form:

$$H^{p_u} = \begin{pmatrix} 1 & 0 & \dots & 0 & 0 \\ 1 & 1 & 0 & \dots & 0 \\ 0 & 1 & 1 & 0 & \dots \\ \dots & \dots & \dots & \dots & \dots \\ 0 & \dots & 0 & 1 & 1 \end{pmatrix} \qquad (50)$$

The choice of this structure for H has been motivated by the fact that aside from being systematic, we obtain a LDPC code which is encodable in linear time in the codeword length *n.* In particular, with this structure, the encoding operation is as follows:

$$p_{u_i} = \begin{cases} \left[\sum_{j=1}^{k} u_j \cdot H_{i,j}^u\right](\text{mod } 2) & i = 1 \\ \left[p_{u_{i-1}} + \sum_{j=1}^{k} u_j \cdot H_{i,j}^u\right](\text{mod } 2) & i = 2,\dots,n-k \end{cases} \qquad (51)$$

where, $H_{j,k}^u$ represents the element *(i,j)* of the matrix $H^u$ , and $u_j$ is the *j*-th bit of the source sequence u.

The starting point in our development shall be the mathematical development behind joint soft decision decoding of LDPC codes.

Let *Z* be a random variable in Galois Field GF(2) assuming values from the set {+1, -1} with equal probability, where +1 is the "null" element under the modulo-2 addition. As explained in [1], the log-likelihood ratio of a binary random variable *Z* is defined as $L_Z(z) = \log\left[\dfrac{P_z(z = +1)}{P_z(z = -1)}\right]$, where $P_z(z)$ is the probability that the random variable *Z* takes on the value *z*. Under the modulo-2 addition, it is easy to prove that for statistically independent random variables *X* and *Y* the following relation is valid:

$$P(X \oplus Y = +1) = P(X = +1)P(Y = +1) + \\ + (1 - p(X = +1))(1 - p(Y = +1)) \qquad (52)$$

Hence, for *Z = X ⊕ Y*:

$$P_z(z = +1) = \frac{e^{L_z(z)}}{1 + e^{L_z(z)}} \qquad (53)$$

Furthermore, the following approximation holds:

$$L_z(z) = \log\left[\frac{1 + e^{L_X(x)} e^{L_Y(y)}}{e^{L_X(x)} + e^{L_Y(y)}}\right] \approx sign(L_X(x)) \cdot sign(L_Y(y)) \cdot \min(|L_X(x)|, |L_Y(y)|) \qquad (54)$$

The LDPC decoder operates on a block of encoded data at a time. In order to simplify the notation, boldface $\mathbf{u}_1$ indicate blocks of data bits, while $u_{lj}$ indicate the j-th bit in a frame. Sequence $\mathbf{u}_1$ is composed of the bits $u_{lj}$ for $j=l,...,k$. A similar notation is used for the sequence $\mathbf{u}_2$. Furthermore, we shall formulate the metric evaluations for the received data associated with other source $\mathbf{u}_2$ as well. Let us denote the log-likelihood ratio associated with the information bits $\mathbf{u}_1$ by $L(\mathbf{u}_1)$, thus avoiding the use of a subscript equal to the name of random variable. With reference to the architecture of the joint decoder depicted in Fig. (8), we note that there are two stages of iterative decoding. Index $i$ denotes *global iteration* whereby during each global iteration, the updated estimate of the source correlation obtained during the previous global iteration is passed on the sum-product decoder that performs *local iteration* with a pre-defmed stopping criterion and/or a maximum number of local decoding iterations. With reference to such an architecture, we use the following notation:

- $L_{ex}^{(i-1)}(\hat{\mathbf{u}}_1)$ and $L_{ex}^{(i-1)}(\hat{\mathbf{u}}_2)$ denote the log-likelihood ratios of the extrinsic information associated with the estimated source bits $\hat{u}_1$ and $\hat{u}_2$ at the input of the LDPC decoders;

- $L_c(r_1)$ and $L_c(r_2)$ denote the log-likelihood ratios of the encoded bits coming from the channel at the output of matched filter at the receiver;

- $L^{(1)}(\mathbf{u}_1)$ and $L^{(1)}(\mathbf{u}_2)$ denote the log-likelihood ratios related to the estimated information bits $\hat{\mathbf{u}}_1$ and $\hat{\mathbf{u}}_2$ at the output of the LDPC decoders;

- $\hat{\mathbf{u}}_1^{(i)}$ and $\hat{\mathbf{u}}_2^{(i)}$ represents the hard estimates of the transmitted source bits $\hat{u}_1$ and $\hat{u}_2$ .

Based on the notation above, we can now develop the algorithm for exploiting the source correlation in the LDPC decoder. Consider a *(n,k)*-LDPC identified by the matrix $H^{(n-k.n)}$ as expressed in (49). Note that we only make reference to maximum rank matrix H since the particular structure assumed for H ensure this. In particular, the double diagonal on the parity side of the H matrix always guarantees that the rank of $H$ is equal to the number of its rows, *n-k*.
It is well known that the parity check matrix H can be described by a bipartite graph with two types of nodes: *n* bit-nodes corresponding to the LDPC code bits, and *n-k* check nodes corresponding to the parity cheeks as expressed by the rows of the matrix H. Let B(m) denote the set of bit-nodes connected to the *m*-th check node, and *C(n)* denote the set of the check-nodes adjacent to the *n*-th bit-node. With this setup, *B(m)* corresponds to the set of positions of the 1's in the *m*-th row *of H,* while *C(n)* is the set of positions of the 1's in the *n*-th column of *H*. In addition, let us use the notation *C(n)\m* and *B(m)\n* to mean the sets *C(n)* and *B(m)* in which the *m*-th check-node and the *n*-th bit-node respectively, are excluded. Furthermore, let us identify with $\lambda_{n,m}(u_n)$ the log-likelihood of the message that the *n*-th bit-node sends to the m-th check-node, that is, the LLR of the probability that n-th bit-node is 1 or 0 based on all checks involving the *n*-th bit except the *m*-th check, and with $\Lambda_{n,m}(u_n)$ the log-likelihood of the message that the m-th check-node sends to the n-th bit-node, that is, the LLR of the probability that n-th bit-node is 1 or 0 based on all the bit-nodes checked by the m-th check except the information coining from the *n*-th bit-node. With this setup, we have the following steps of the sum-product algorithm:
*Initialization Step:* each bit-node is assigned an a-posteriori LLR composed of the sum of the a-posteriori probabilities $L_c(r)$ evaluated from the sufficient statistic from the matched filter as follows:

$$L_c(r_{1,j}) = \log\left(\frac{P(u_{1,j} = 1|r_{1,j})}{P(u_{1,j} = 0|r_{1,j})}\right) = \frac{2}{\sigma_n^2} r_{1,j}, \quad \forall j = 1,...,n \qquad (55)$$

plus an extrinsic LLR added only to the systematic bit nodes, i.e., to the bit nodes $u_{1,j}, \forall j = 1,..., k$ . In (55), $\sigma_n^2$ is the noise variance at the matched filter output due to the AWGN channel. In summary, for any position (m, n) such that $H_{m,n} = 1$, set:

$$\lambda_{m,n}\left(u_n\right)=\begin{cases}L_c\left(r_{1,j}\right)+L_{ex}^{(i-1)}\left(\hat{u}_{1,j}\right) & j=1,\ldots,k \\ L_c\left(r_{1,j}\right) & j=k+1,\ldots,n\end{cases} \tag{56}$$

and

$$\Lambda_{m,n}\left(u_n\right)=0 \tag{57}$$

*(1) Check-node update:* for each $m=1,\ldots,n-k,$ and for each $n \in B(m),$ compute:

$$\Lambda_{m,n}\left(u_{1,n}\right)=2\tanh^{-1}\left(\prod_{p\in B(m)\backslash n}\tanh\left(\frac{\lambda_{p,m}\left(u_{1,p}\right)}{2}\right)\right) \tag{58}$$

*(2) Bit-node update:* for each $t=1,\ldots,n$ , and for each $m \in C(t)$ compute:

$$\lambda_{t,m}\left(u_{1,t}\right)=L_c\left(r_{1,t}\right)+L_{ex}^{(i-1)}\left(\hat{u}_{1,t}\right)+\sum_{p\in C(t)\backslash m}\Lambda_{p,n}\left(u_{1,t}\right) \tag{59}$$

*(3) Decision:* for each node $u_{1,t}$ with t = 1,...,$n$ , compute:

$$\lambda_t\left(u_{1,t}\right)=\begin{cases}L_c\left(r_{1,t}\right)+L_{ex}^{(i-1)}\left(\hat{u}_{1,t}\right)+\sum_{p\in C(t)}\Lambda_{p,n}\left(u_{1,t}\right) & t=1,\ldots,k \\ L_c\left(r_{1,t}\right)+\sum_{p\in C(t)}\Lambda_{p,n}\left(u_{1,t}\right) & t=k+1,\ldots,n\end{cases} \tag{60}$$

and quantize the results such that $u_{1,t}=0$ if $\lambda_t(\mu_{1,t})<0$ , and $u_{1,t}=1$ otherwise.

If $H\cdot \mathbf{u}_1^{\mathbf{T}}=\mathbf{0}$ then halt the algorithm and output $U_{1,t}$, $t=1,\ldots,k,$ as the estimate of the transmitted source bits, $u_1$, corresponding to the first source. Otherwise, if the number of iterations is less than a predefined maximum number, iterate the process starting from step (1). The architecture of the joint channel decoder is depicted if Fig. (8). Let us elaborate on the signal processing involved. In particular, as before let $u_1$ and $u_2$ be two correlated binary random variables which can take on the values {+1, -1} and let $z = u_1 \oplus u_2$. Let us assume that random variable z takes on the values {+1, -1} with probabilities $P_z(z = +1) = p_z$ and $P_z(z = -1) = 1 - p_z$.

The log-likelihood ratios $L_z^{(i)}\left(z\right)$ related at global iteration (i) are evaluated as follows:

$$L_z^{(i)}\left(z\right)=\log\left(\frac{1-p_{\hat{z}}}{p_{\hat{z}}}\right) \tag{61}$$

by counting the number of places in which $\hat{\mathbf{u}}_1^{(i)}$ and $\hat{\mathbf{u}}_2^{(i)}$ differ, or equivalently by evaluating the Hamming weight $w_H$

$(\cdot)$ of the sequence $\hat{z}^{(i)} = \hat{\mathbf{u}}_1^{(i)} \oplus \hat{\mathbf{u}}_2^{(i)}$ whereby, in the previous equation, $p_{\hat{z}} = \dfrac{w_H\left(\hat{z}^{(i)}\right)}{L}$. In the latter case, by assuming that the sequence z = **u**$_1$ ⊕ **u**$_2$ is i.i.d., we have:

$$L_z^{(i)}(z) = \log\left(\frac{k - w_H(\hat{z}^{(i)})}{w_H(\hat{z}^{(i)})}\right) \tag{62}$$

where k is the data block size.

Finally, applying (54) we can obtain an estimate of the extrinsic information on the source bits for the next iteration:

$$L_{ex}^{(i)}(\hat{\mathbf{u}}_1) = L(\hat{z}^{(i)} \oplus \hat{\mathbf{u}}_2^{(i)}) \tag{63}$$

and

$$L_{ex}^{(i)}(\hat{\mathbf{u}}_2) = L(\hat{z}^{(i)} \oplus \hat{\mathbf{u}}_1^{(i)}) \tag{64}$$

Note that as far as the LLR of the difference sequence Z is concerned, a correlation of for instance 10% or 90% between $u_1$ and $u_2$ carry the same *amount* of information. Hence, the performance gain of the iterative joint decoder in either case is really the same (we have verified this experimentally). From an information theoretic point of view, all this says is that the entropy of the random variable Z is symmetric about the 50% correlation point.

Formally, the joint decoding algorithm can be formalized as follows:

1) Set the log-likelihood ratios $L_{ex}^{(0)}(\hat{\mathbf{u}}_1)$ and $L_{ex}^{(0)}(\hat{\mathbf{u}}_2)$ to zero (see Fig. (8)). Compute the log-likelihood ratios for the channel outputs using (55) for both received sequences $r_1$ and $r_2$.

2) For iteration $i=1,...,q$, perform the following:

a) Perform a sum-product decoding for both received sequences $r_1$ and $r_2$ by using a predefined maximum number of iterations and extrinsic information $L_{ex}^{(i-1)}(\hat{\mathbf{u}}_1)$ and $L_{ex}^{(i-1)}(\hat{\mathbf{u}}_2)$;

b) Evaluate $L_Z^{(i)}(z)$ using equation (62);

c) Evaluate $L_{ex}^{(i)}(\hat{\mathbf{u}}_1)$ and $L_{ex}^{(i)}(\hat{\mathbf{u}}_2)$ by using (63) and (64);

d) Go back to (a) and continue until the last global iteration $q$.

SIMULATION RESULTS

We have simulated the performance of our proposed iterative joint channel decoder. We assume that our transmit nodes use the same LDPC codes and the SNR of each of the two received sequences are the same. In the following, we provide sample simulation results associated with a *(n, k)* = (504, 252) LDPC code designed in order to reduce the number of length 4 and 6 cycles in the Tanner graph of the code. In particular, the designed H has only six cycles of length 6 and 12184 cycles of length 8. Average degree distributions of the bit- and check-nodes of the considered LDPC are, respectively, 3 and 6. Furthermore, sub-matrix $H^U$ has been designed with an uniform bit-node degree distribution equal to 4. For local decoding of the LDPC code, the maximum number of iterations has been set to 80. We note that as far as the matrix H of the LDPC is concerned, it is clear that any design criteria already proposed in the literature can be employed, provided that the LDPC considered is systematic.

The simulation results are reported as follows:

1) Figure (9a) shows the BER of the correlated sources for a correlation coefficient $p = 0.99$, and for various number of global iterations. For comparison purposes, the curve labeled "LDPC(504,252)-80 it." shows the performance of the LDPC without using the implicit correlation information. Several observations are in order:

a) 3- or 4- global iterations suffice to get almost all that can be gained from the knowledge of the cross-correlation. We note that our comparison of the simulation results with the analytical performance bounds presented below, reinforce this statement;

b) since the estimates of the cross-correlation are noisy at sufficiently low SNR levels, decoding iterations are critical for improving performance, otherwise 2-iterations are often sufficient to obtain most of the achievable gain;

c) as the cross-correlation approaches 0.5, the achievable gains diminish as expected and reduces to zero at $p = 0.5$. This implies that when the two sequences are totally uncorrelated, the performance of the iterative joint channel decoder is no better than the case each received sequence is independently decoded. On the other hand, when the cross-correlation level is nearly one or zero, the achievable coding gain is a function of the operating BER and diminishes as BER decreases.

2) Figure (9b) shows the BER as a function of SNR and p at the end of four decoding iterations.

Figure (9c) shows simulation results and comparison to upper-bound (denoted UB) at two values of $p$. In figure (9d) we show the empirical density functions of the LLR values that tend to be Gaussian. In Figure (9e) we show in a table the average number of local iterations performed by the joint decoder at the end of a given global iteration, for two values of correlation between the sources. For comparison, we show the average number of local iterations performed by the LDPC decoder without using extrinsic information derived from source correlation. It is evident that aside from the raw coding gain, there is a significant speed-up of the sum-product decoder with increasing number of global iterations.

As a result, the present invention provides a technique for enhancing the decoding of channel encoded data by exploiting an inherent correlation between individual data packets in that for instance soft decision criteria are adjusted on the basis of a value characterizing the inherent correlation.

**Claims**

1. A method of information processing comprising:

    generating a first piece of information and a second piece of information in a timely related manner,
    transmitting at least said first piece of information from a first source to a second source over a first transmission channel and
    decoding at least said first piece of information at said second source by using an estimated correlation of said transmitted first piece of information and said second piece of information available at said second source at the time of decoding at least said first piece of information.

2. The method of claim 1, wherein decoding at least said first piece of information comprises iteratively decoding said first piece of information using a soft decision algorithm.

3. The method of claim 2, wherein iteratively decoding at least said first piece of information comprises partially decoding said first piece of information with a first iteration step, estimating a first correlation value relating said partially decoded first piece of information to said second piece of information and using said first correlation value in decoding said first piece of information in a second iterative step.

4. The method of claim 3, wherein said first correlation value is used to readjust at least one decision criterion of said soft decision algorithm.

5. The method of claim 3 or 4, wherein iteratively decoding said first piece of information comprises partially decoding said first piece of information as obtained after said second iterative step, estimating a second correlation value relating said first piece of information partially decoded twice to said second piece of information and using said second correlation value in decoding said first piece of information in a third iterative step and so on until a desired fixed total number of iterations have been achieved.

6. The method of any of claims 1 to 5, wherein said second piece of information is transmitted to said second source via a second transmission channel.

**7.** The method of any of claims 1 to 5, wherein said second piece of information is transmitted via said first transmission channel.

**8.** The method of any of claims 1 to 5, wherein said first piece of information is generated at said first source and said second piece of information is generated at said second source.

**9.** The method of claim 6, wherein said first piece of information is generated at said first source and said second piece of information is generated at a third source.

**10.** The method of claim 7, wherein said first and second pieces of information are generated at said first source.

**11.** The method of any of claims 1 to 10, wherein said first piece of information is one of a plurality of first pieces of information that are transmitted via a plurality of first transmission channels including said first transmission channel to a plurality of second sources including said second source, each of the plurality of first sources at least transmitting at least one of the plurality of first pieces of information, each of the plurality of second sources receiving at least one of said plurality of first pieces of information, each of the plurality of second sources having access to at least one of a plurality of second pieces of information including said second piece of information, the method further comprising decoding said plurality of first pieces of information at said plurality of second sources using respective estimated correlations of said plurality of first pieces of information with said plurality of second pieces of information.

**12.** The method of any of claims 1 to 11, further comprising transmitting said first piece of information with or without data compression prior to any channel encoding of the first piece of information.

**13.** The method of any of claims 1 or 12, further comprising determining said estimated correlation by comparing first data bits representing said first piece of information with second data bits representing said second piece of information by a logic operation.

**14.** The method claim 13, further comprising obtaining said estimated correlation by determining a comparison result on the basis of a number of agreements of the comparison and normalizing said comparison result.

**15.** The method of any of claims 1 to 14, wherein said first and second pieces of information are iteratively decoded.

**16.** The method of claim 3 and 16, further comprising determining said first correlation value after a first iterative step for the first and second pieces of information and using said first correlation value in a second step of decoding the first and second pieces of information.

**17.** The method of any of claims 1 to 16, further comprising channel encoding at least said first piece of information.

**18.** The method of claim 17, wherein channel encoding at least said first piece of information comprises low density parity check encoding or any other block coding said first piece of information.

**19.** The method of claim 17, wherein channel encoding at least said first piece of information comprises using a serially concatenated convolutional code or any other convolutional encoding scheme with or without concatenation of more than one code, be it concatenated block, convolutional or mixed block and convolutional codes.

**20.** The method of any of claims 17 to 19, wherein said second piece of information is channel encoded by the same encoding method as the first piece of information.

**21.** A method of channel decoding at least first data representing a first piece of information generated by a first source and second data representing a second piece of information generated by a second source, the first and second data having a specified degree of correlation, the method comprising:

receiving said first and second data,
decoding at least said first data in a first step,
determining an estimate of said degree of correlation on the basis of said first data decoded in said first step and said second data, and
decoding at least said first data in a second step on the basis of said estimate.

**22.** The method of claim 21, wherein decoding at least said first data includes decoding said second data.

**23.** The method of claim 21 or 22, wherein determining an estimate of said degree of correlation comprises determining a first correlation value based on a comparison of the first and second data, the method further comprising using said first correlation value to readjust a decision criterion in said second step.

**24.** A communication network comprising:

a first node including a channel encoder configured to encode a first piece of information,
a second node including a channel decoder configured to decode said channel coded first piece of information on the basis of an estimated correlation between said first piece of information and a second piece of information communicated over said network and being available at the second node at the time of decoding said first piece of information, and a correlation estimator configured to provide a value indicating said estimated correlation to said channel decoder, and
a communication medium providing one or more communication channels and being connected to the first and second nodes and being configured to convey at least said channel coded first piece of information to said second node.

**25.** The communication network of claim 24, wherein said channel decoder comprises an iterative soft decision decoder.

**26.** The communication network of claim 24 or 25, further comprising a third node including a channel encoder configured to encode said second piece of information, said third node being connected to said communication medium for conveying said second piece of information to said second node.

**27.** The communication network of claim 24 or 25, wherein said channel encoder of said first node is configured to encode said second piece of information for transmission over said communication medium.

**28.** The communication network of claim 24 or 25, wherein said first node is one of a first plurality of nodes and said second node is one of a second plurality of nodes, each of said first plurality including a respective channel encoder configured to encode an associated first piece of information, wherein said second node is one of a second plurality of nodes, each of which includes a respective channel decoder configured to decode said channel coded first pieces of information on the basis of an estimated correlation between said first pieces of information and a plurality of second pieces of information including said second piece of information, one of said second pieces of information being available at each of said second nodes and wherein each of said second nodes includes a respective correlation estimator.

**29.** The communication network of any of claims 24 to 28, further comprising a platform configured to execute one or more applications that produce said first and second pieces of information, said platform at least being connected to said first node.

**30.** The communication network of claim 29, wherein said one or more applications are associated with one or more hardware units, at least one hardware unit being coupled with said first node.

**31.** The communication network of claim 30, wherein at least one hardware unit is coupled with said third node.

**32.** The communication network of claim 29, wherein said one or more hardware units each comprise a sensor element.

**33.** The communication network of any of claims 24 to 33, wherein power resources and/or computational resources available at said first node are less compared to power resources and/or computational resources available at said second node.

**34.** A channel decoder comprising:

an input section configured to receive a first signal and a second signal and to demodulate said first and second signals to produce first and second data representing a first piece of information and a second piece of information, respectively, at least said first signal being a channel-coded signal,
a correlation estimator configured to receive said first data and said second date and to determine a correlation value defining a degree of correlation between said first and second data, and

a decoder section connected to said input section and said correlation estimator, said decoder section being configured to decode at least said first data on the basis of said correlation value.

35. The channel decoder of claim 34, wherein said decoder section comprises an iterative soft decision decoder configured to adjust at least one soft decision threshold on the basis of said correlation value.

36. The channel decoder of claim 35, wherein said correlation estimator is configured to receive a decoded version of said first data after a first iterative step and to provide an updated correlation value to said decoder for a subsequent iterative step.

37. The channel decoder of any of claims 34 to 37, wherein said decoder section is configured to decode said first data and said second data on the basis of said correlation value.

38. A network node unit comprising
a channel decoder according to any of claims 34 to 37,
a hardware unit connectable to a network and being configured to process at least said decoded first piece of information.

39. The network node unit of claim 38, wherein said hardware unit is further configured to assess a validity of said decoded first piece of information and to transmit an instruction via said network to resend at least said first piece of information.

Fig.1

Fig.2a

Fig.2b

Fig.2c

Fig.3

Fig.4

Fig.5a

38

Fig.5b

Fig.5c

Fig.5d

Fig.5e

Fig.5f

Fig.5g

Fig.5h

Fig.6

Fig.7a

Fig.7b

Fig.7c

Fig.7d

Fig.8

Fig.9a

Fig.9b

Fig.9c

Fig.9d

INDICES.

| $\rho = 99\%$, $E_b/N_0$ | LDPC | 1-th it. | 2-nd it. | 3-rd it. | 4-th it. |
|---|---|---|---|---|---|
| 0.00  dB | 79.43 | 60.5 | 45.5 | 36.1 | 29.0 |
| 0.50  dB | 74.45 | 44.5 | 30.8 | 24.6 | 19.9 |
| 1.00  dB | 49.03 | 28.4 | 19.4 | 16.0 | 12.3 |
| 1.50  dB | 23.34 | 13.9 | 8.1 | 4.9 | 2.3 |
| $\rho = 90\%$, $E_b/N_0$ | LDPC | 1-th it. | 2-nd it. | 3-rd it. | 4-th it. |
| 0.00  dB | 79.43 | 71.8 | 62.6 | 56.1 | 43.0 |
| 0.50  dB | 74.45 | 52.6 | 40.6 | 34.3 | 25.4 |
| 1.00  dB | 49.03 | 30.4 | 22.8 | 18.9 | 14.9 |
| 1.50  dB | 23.34 | 14.3 | 11.1 | 9.5 | 7.8 |

# Fig.9e

European Patent
Office

**EUROPEAN SEARCH REPORT**

Application Number

EP 05 00 6313

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | J. GARCIA-FRIAS: "Joint Source-Channel Decoding of Correlated Sources over Noisy Channels" DATA COMPRESSION CONFERENCE 2001, [Online] 27 March 2001 (2001-03-27), pages 283-292, XP002328487 Retrieved from the Internet: URL:http://ieeexplore.ieee.org/xpls/abs_all.jsp?isnumber=19803&arnumber=917159> [retrieved on 2005-05-18] * the whole document *  ----- | 1-39 | H03M13/37 |
| | | | **TECHNICAL FIELDS SEARCHED** (Int.Cl.7) |
| | | | H03M |

The present search report has been drawn up for all claims

| Place of search | Date of completion of the search | Examiner |
|---|---|---|
| The Hague | 18 May 2005 | Van Staveren, M |

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **J. HAGENAUER ; E. OFFER ; L. PAPKE.** Iterative decoding of binary block and convolutional codes. *IEEE Trans. on Inform. Theory,* March 1996, vol. 42 (2), 429-445
- **L. R. BAHL ; J. COCKE ; F. JELINEK ; J. RAVIV.** Optimal decoding of linear codes for minimizing symbol error rate. *IEEE Trans. On Inform. Theory,* May 1974, vol. IT-20, 284-287
- **C. FRAGOULI ; R.D. WESEL.** Semi-random interleaver design criteria. *Proc. IEEE Globecom,* December 1999, vol. 5, 2352-2356
- **G. MONTORSI ; S. BENEDETTO.** Design of fixed-point iterative decoders for concatenated codes with interleavers. *IEEE Journal on Selected Areas in Communications,* May 2001, vol. 19 (5), 871-882